(19)

**Europäisches Patentamt**

**European Patent Office**

**Office européen des brevets**

(11) **EP 2 940 821 B1**

(12) **EUROPEAN PATENT SPECIFICATION**

(45) Date of publication and mention of the grant of the patent:
**21.02.2018 Bulletin 2018/08**

(51) Int Cl.:
**G01R 29/00** *(2006.01)* **H02H 7/097** *(2006.01)*
**G01R 19/00** *(2006.01)*

(21) Application number: **15165472.0**

(22) Date of filing: **28.04.2015**

(54) **CALCULATING LINE-TO-NEUTRAL VOLTAGES WITHOUT A CONNECTION TO A SYSTEM NEUTRAL OR EARTH GROUND**

BERECHNUNG DER AUSSENLEITER-NEUTRALLEITER-SPANNUNGEN OHNE VERBINDUNG ZU EINEM NEUTRALEN ODER GEERDETEN SYSTEM

CALCUL DES TENSIONS PHASE-NEUTRE SANS UNE CONNEXION À UN NEUTRE SYSTÈME OU MISE À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.04.2014 US 201414263565**

(43) Date of publication of application:
**04.11.2015 Bulletin 2015/45**

(73) Proprietor: **Rockwell Automation Technologies, Inc.**
**Mayfield Heights, OH 44124 (US)**

(72) Inventors:
• **Fieldbinder, Douglas**
**Franklin, WI 53132 (US)**
• **Waydick, Eric**
**Saint Francis, WI 53235 (US)**

• **Drame, Issa V.**
**West Allis, WI 53214 (US)**

(74) Representative: **Grünecker Patent- und Rechtsanwälte**
**PartG mbB**
**Leopoldstraße 4**
**80802 München (DE)**

(56) References cited:
**US-A- 4 887 018    US-B1- 6 466 466**

• **National Instruments: "Calculating Line-to-Line Voltages from Line-to-Neutral Measurements with the NI 9225", , 18 December 2008 (2008-12-18), XP002742378, Retrieved from the Internet: URL:http://www.ni.com/white-paper/8216/en/ [retrieved on 2015-07-16]**

**Description**

The subject matter disclosed herein relates to calculating voltage and more particularly relates to calculating line-to-neutral voltage without a connection to a system neutral or earth ground.

Typical three-phase systems include three alternating current ("AC") voltages that have a fundamental frequency, such a 50 hertz ("Hz"), 60 Hz, 400 Hz, etc. that are offset in time so that the three phases are spaced 120 degrees within one cycle. A three-phase power system can supply power to three-phase loads as well as single-phase loads. Many three-phase loads, such as motors are balanced loads under normal operating conditions and do not require a neutral connection. Other loads may also not require a neutral connection, such as the primary side of a transformer in a delta-wye or delta-delta configuration. Measurement of voltages within a three-phase power system can be important for a variety of reasons, such as power quality monitoring, overcurrent protection, power monitoring, etc.

Some three-phase power systems have neutral connections available for some loads while other three-phase loads do not have a neutral connection available. Often power systems have a connection between the neutral, which is also called the grounded conductor, and a system ground, such as earth ground or a ground to a structure. For safety reasons, a grounding conductor, which is usually marked green or is bare copper, is run with power conductors to a load. This grounding conductor may be called a safety ground and typically connects to structures and frames of equipment being powered in the three-phase power system to provide a low impedance path for fault current. The safety ground is often nearly the same potential as the neutral, however, when current flows in the neutral, voltage drop from the load to the neutral to ground connection, which is usually at a three-phase power source for a system, can be substantial. In fault conditions, at a load voltage between a neutral and a safety ground can vary significantly so determining line-to-neutral voltage by simply measuring line-to-ground can be inaccurate, especially under fault conditions.

Some three-phase power systems are isolated from a grounded structure. For example, some three-phase power systems in marine vessels are isolated from the grounded structure of the vessel. For loads in such an ungrounded system that do not have a neutral available, line-to-neutral voltage measurements are not available. Having a line-to-neutral voltage available for loads with no available neutral connection and for three-phase power systems that are floating is desirable for a variety of reasons.

US 6 466 466 B1 relates to a stable artificial neutral point in a three phase network of single phase rectifiers. An electric supply system comprising two or more phases (R2, S2, T2), one rectifier (101, 103, 105) for each phase, the second primary terminals of said rectifiers (101, 103, 105) being interconnected, also comprises an Artificial Neutral Point (ANP) creating means (A2) for creating an artificial neutral point (NA2) in the electric supply system, connected in parallel with said rectifiers. The ANP means (A2) short-circuits the zero sequence voltage component of the system but does not affect the positive and negative sequence components. The ANP means (A2) includes magnetic components of such a kind that the vector sum of the phase voltages is zero. According to a first embodiment, the ANP means (A2) comprises one transformer (113, 115, 117) for each phase, the primary winding of each transformer connected to the respective phase (R2, S2, T2) in a star configuration, the secondary windings serially connected and the interconnection point of the primary windings forming an artificial neutral point.

US 4 887 018 A relates to a line to line to line to neutral converter. A reduced voltage starter for gradually starting a polyphase motor having an acceleration control circuit for gradually applying power to the motor and detector circuits for detecting various fault conditions for terminating power to the motor. A shorted solid state switch detector senses when one of the semiconductor switches applying power to the motor is shorted to terminate the application of power from the remaining phases. A phase angle control circuit insures a uniform application of power to the motor. A phase rotation detection circuit detects when the three phases are in other than their correct sequence and terminates power in the event of such detection. An underload detection circuit senses when the current drops beneath a preselected reference after the motor has reached its full speed and terminates power in response to such detection. A line-to-line-to-line-to-neutral convertor produces signals representative of the line-to-neutral voltages which are necessary for other circuit functions.

National Instruments, "Calculating Line-to-Line Voltages from Line-to-Neutral Measurements with the NI 9225", December 18, 2008, pages 1 to 3, relates to the calculation of line-to-line values on a three phase 240V system from line to neutral measurements.

SUMMARY

It is the object of the present invention to provide an improved method for determining a line-to-neutral voltage, as well as a corresponding apparatus.

This object is solved by the subject matter of the independent claims.

Preferred embodiments are defined by the dependent claims.

A method for determining voltage is disclosed. An apparatus and computer program product also perform the functions of the method. The method for determining voltage includes measuring three line-to-line voltages for the phases in a three-phase power system, where each line-to-line voltage includes a voltage magnitude, and constructing, on a two-dimensional coordinate system with an origin, a phasor triangle that includes the three line-to-line voltages represented as phasors. A first phasor $V_{ab}$ originates at a first point and extends in a direction along a horizontal axis of the coordinate system to the origin and a second phasor $V_{bc}$ extends between the origin and a second point. The second point is in a direction vertically and horizontally from the origin. A third phasor $V_{ca}$ extends between the second point and the first point.

The method, in one embodiment, includes adding a first line segment that extends from a point that bisects the second phasor $V_{bc}$ in a direction perpendicular to the second phasor $V_{bc}$ and away from the phasor triangle. The first line segment terminates at a third point. The method, in another embodiment, includes adding a second line segment that extends from a point that bisects the third phasor $V_{ca}$ in a direction perpendicular to the third phasor $V_{ca}$ and away from the phasor triangle. The second line segment terminates at a fourth point. In one embodiment, the method includes adding a third line segment from the third point to the first point and adding a fourth line segment from the fourth point to the origin, where the third line segment intersects the fourth line segment at a neutral point. The method, in another embodiment, includes determining a line-to-neutral voltage. The line-to-neutral voltage includes a line from the neutral point to a vertex of the phasor triangle.

In one embodiment, determining a line-to-neutral voltage may include determining a line-to-neutral voltage for a phasor $V_{an}$ for phase A which includes determining a line from the neutral point to the first point, determining a line-to-neutral voltage for a phasor $V_{bn}$ for phase B which includes determining a line from the neutral point to the origin, and/or determining a line-to-neutral voltage for a phasor $V_{cn}$ for phase C which includes determining a line from the neutral point to the second point. In another embodiment, the method includes determining a magnitude of phasor $V_{an}$ as

$$V_{an} = \sqrt{(x_a - x_n)^2 + (y_a - y_n)^2};$$

determining a magnitude of phasor $V_{bn}$ as

$$V_{bn} = \sqrt{(x_b - x_n)^2 + (y_b - y_n)^2};$$

and determining a magnitude of phasor $V_{cn}$ as

$$V_{cn} = \sqrt{(x_c - x_n)^2 + (y_c - y_n)^2}.$$

In one embodiment, the first point has a coordinate of $(x_a, y_a)$, the second point has a coordinate of $(x_c, y_c)$, and the origin has a coordinate of $(x_b, y_b)$ and $x_a$ = the magnitude of the $V_{ab}$ phasor *and* $y_a = 0$, $x_b = 0$ *and* $y_b = 0$,

$x_c = \frac{V_{ab}^2 - V_{ca}^2 + V_{bc}^2}{2 \cdot V_{ab}}$ and $y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)}$, where $V_{ab}$ is a magnitude of the first phasor $V_{ab}$, $V_{bc}$

is a magnitude of the second phasor $V_{bc}$, and $V_{ca}$ is a magnitude of the third phasor $V_{ca}$. In one embodiment, the length of the first line segment has a magnitude of the third phasor $V_{ca}$ divided by the square root of three and multiplied by the square root of one plus the square of the slope of the first line segment and the length of the second line segment has a magnitude of the second phasor $V_{bc}$ divided by the square root of three and multiplied by the square root of one plus the square of the slope of the second line segment.

In another embodiment, the length of the first line segment is:

$$\frac{V_{ca}}{\sqrt{3}} \cdot \sqrt{1 + \left(\frac{-x_c}{y_c}\right)^2}$$

and the length of the second line segment is

$$\frac{V_{bc}}{\sqrt{3}} \cdot \sqrt{1 + \left(\frac{-(x_a - x_c)}{(y_a - y_c)}\right)^2}.$$

In one embodiment, the third point has a coordinate of ($x_{pbc}$, $y_{pbc}$) and the fourth point has a coordinate of ($x_{pca}$, $y_{pca}$), where

$$x_{pbc} = \frac{x_c}{2} - \frac{V_{ca}}{\sqrt{3}};$$

$$y_{pbc} = \frac{y_c}{2} - \frac{-x_c}{y_c} \cdot \frac{V_{ca}}{\sqrt{3}};$$

$$x_{pca} = x_c + \frac{x_a - x_c}{2} + \frac{V_{bc}}{\sqrt{3}};$$

and

$$y_{pca} = \frac{y_c}{2} + \frac{-(x_a - x_c)}{(y_a - y_c)} \cdot \frac{V_{bc}}{\sqrt{3}}.$$

In another embodiment, the neutral point has a coordinate of ($x_n$, $y_n$), where:

$$x_n = \frac{\dfrac{y_{pbc}}{x_a - x_{pbc}} \cdot x_a}{\dfrac{y_{pca}}{x_{pca}} + \dfrac{y_{pbc}}{x_a - x_{pbc}}};$$

and

$$y_n = \frac{y_{pca}}{x_{pca}} \cdot x_n.$$

In another embodiment, *where* $y_n$ is less than zero then $y_n = 0$, and where $y_n$ is greater than or equal to zero and greater than $y_c$ then $y_n = y_c$. In another embodiment, where $x_n$ is less than zero then $x_n = 0$, and where $x_n$ is greater than or equal to zero and greater than $x_a$ then $x_n = x_a$, and where $x_n$ is greater than or equal to zero and less than or equal to $x_a$ and $y_c = y_n$ then $x_n = x_c$.

In one embodiment, the length of the first line segment has a magnitude of the second phasor $V_{bc}$ multiplied by the square root of three and divided by two, which represents a height of a first equilateral triangle constructed on the second phasor $V_{bc}$ and extending away from the phasor triangle and the length of the second line segment has a magnitude of the third phasor $V_{ca}$ multiplied by the square root of three and divided by two, which represents a height of a second equilateral triangle constructed on the third phasor $V_{ca}$ and extending away from the phasor triangle. In another embodiment, the third point has a coordinate of ($x_{pbc}$, $y_{pbc}$) and the fourth point has a coordinate of ($x_{pca}$, $y_{pca}$), where:

$$x_{pbc} = \frac{x_c - y_c \cdot \sqrt{3}}{2};$$

$$y_{pbc} = \frac{y_c + x_c \cdot \sqrt{3}}{2};$$

$$x_{pca} = x_a + \frac{x_c - x_a + \sqrt{3} \cdot y_c}{2};$$

and

$$y_{pca} = \frac{(y_c - y_a) + \sqrt{3} \cdot (x_a - x_c)}{2}.$$

In another embodiment, the neutral point has a coordinate of $(x_n, y_n)$ where:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}};$$

and

$$y_n = \frac{y_{pca}}{x_{pca}} \cdot x_n.$$

In one embodiment, the line-to-line voltages are measured at a location in the three-phase power system where a neutral connection is unavailable for measurement. In another embodiment, the three-phase power system includes an ungrounded power system. In another embodiment, the three-phase power system includes unbalanced voltages. In another embodiment, the first phasor $V_{ab}$, the second phasor $V_{bc}$, and the third phasor $V_{ca}$ are separated by 120 degrees.

An apparatus for determining voltages, in one embodiment, includes a measurement module that measures three line-to-line voltages for the phases in a three-phase power system, where each line-to-line voltage includes a voltage magnitude. The apparatus, in one embodiment, includes a triangle module that constructs, on a two-dimensional coordinate system with an origin, a phasor triangle with the three line-to-line voltages represented as phasors, where a first phasor $V_{ab}$ originates at a first point and extends in a direction along a horizontal axis of the coordinate system to the origin, a second phasor $V_{bc}$ extends between the origin and a second point, the second point in a direction vertically and horizontally from the origin, and a third phasor $V_{ca}$ extends between the second point and the first point.

The apparatus, in one embodiment, includes a first line module that adds a first line segment that extends from a point that bisects the second phasor $V_{bc}$ in a direction perpendicular to the second phasor $V_{bc}$ and away from the phasor triangle. The first line segment terminates at a third point. In another embodiment, the apparatus includes a second line module that adds a second line segment that extends from a point that bisects the third phasor $V_{ca}$ in a direction perpendicular to the third phasor $V_{ca}$ and away from the phasor triangle. The second line segment terminates at a fourth point. The apparatus, in one embodiment, includes a third line module that adds a third line segment from the third point to the first point and a fourth line module that adds a fourth line segment from the fourth point to the origin, where the third line segment intersects the fourth line segment at a neutral point. The apparatus, in another embodiment, includes a line-to-neutral module that determines a line-to-neutral voltage. The line-to-neutral voltage includes a line from the neutral point to a vertex of the phasor triangle.

In one embodiment, the line-to-neutral module determines a line-to-neutral voltage by determining a line-to-neutral voltage for phasor $V_{an}$ for phase A which includes determining a line from the neutral point to the first point. In another embodiment, the line-to-neutral module determines a line-to-neutral voltage by determining a line-to-neutral voltage for phasor $V_{bn}$ for phase B which includes determining a line from the neutral point to the origin. In another embodiment, the line-to-neutral module determines a line-to-neutral voltage by determining a line-to-neutral voltage for phasor $V_{cn}$ for phase C which comprises determining a line from the neutral point to the second point. For example, the apparatus may include a line-to-neutral magnitude module that determines a magnitude of phasor $V_{an}$ as

$$V_{an} = \sqrt{(x_a - x_n)^2 + (y_a - y_n)^2},$$

determines a magnitude of phasor $V_{bn}$ as

$$V_{bn} = \sqrt{(x_b - x_n)^2 + (y_b - y_n)^2},$$

and/or determines a magnitude of phasor $V_{cn}$ as

$$V_{cn} = \sqrt{(x_c - x_n)^2 + (y_c - y_n)^2}.$$

In one embodiment, first point has a coordinate of $(x_a, y_a)$, the second point has a coordinate of $(x_c, y_c)$, and the origin has a coordinate of $(x_b, y_b)$ where $x_a$ = the magnitude of the $V_{ab}$ phasor and $y_a = 0$, $x_b = 0$ and $y_b = 0$, and

$x_c = \frac{V_{ab}^2 - V_{ca}^2 + V_{bc}^2}{2 \cdot V_{ab}}$ and $y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)}$. $V_{ab}$ is a magnitude of the first phasor $V_{ab}$, $V_{bc}$ is a magnitude of the second phasor $V_{bc}$, and $V_{ca}$ is a magnitude of the third phasor $V_{ca}$.

In one embodiment, the length of the first line segment has a magnitude of the third phasor $V_{ca}$ divided by the square root of three and multiplied by the square root of one plus the square of the slope of the first line segment and the length of the second line segment has a magnitude of the second phasor $V_{bc}$ divided by the square root of three and multiplied by the square root of one plus the square of the slope of the second line segment.

In another embodiment, the third point has a coordinate of $(x_{pbc}, y_{pbc})$ and the fourth point has a coordinate of $(x_{pca}, y_{pca})$, where

$$x_{pbc} = \frac{x_c}{2} - \frac{V_{ca}}{\sqrt{3}};$$

$$y_{pbc} = \frac{y_c}{2} - \frac{-x_c}{y_c} \cdot \frac{V_{ca}}{\sqrt{3}};$$

$$x_{pca} = x_c + \frac{x_a - x_c}{2} + \frac{V_{bc}}{\sqrt{3}};$$

and

$$y_{pca} = \frac{y_c}{2} + \frac{-(x_a - x_c)}{(y_a - y_c)} \cdot \frac{V_{bc}}{\sqrt{3}}.$$

In one embodiment, the neutral point has a coordinate of $(x_n, y_n)$, where:

$$x_n = \frac{\frac{y_{pbc}}{x_a - x_{pbc}} \cdot x_a}{\frac{y_{pca}}{x_{pca}} + \frac{y_{pbc}}{x_a - x_{pbc}}};$$

and

$$y_n = \frac{y_{pca}}{x_{pca}} \cdot x_n.$$

In one embodiment, where $y_n$ is less than zero then $y_n = 0$, and where $y_n$ is greater than or equal to zero and greater than $y_c$ then $y_n = y_c$. In another embodiment, where $x_n$ is less than zero then $x_n = 0$, and where $x_n$ is greater than or equal to zero and greater than $x_a$ then $x_n = x_a$, and where $x_n$ is greater than or equal to zero and less than or equal to $x_a$ and $y_c = y_n$ then $x_n = x_c$.

In one embodiment, the length of the first line segment has a magnitude of the second phasor $V_{bc}$ multiplied by the square root of three and divided by two, which represents a height of a first equilateral triangle constructed on the second phasor $V_{bc}$ and extending away from the phasor triangle and the length of the second line segment has a magnitude of the third phasor $V_{ca}$ multiplied by the square root of three and divided by two, which represents a height of a second equilateral triangle constructed on the third phasor $V_{ca}$ and extending away from the phasor triangle. For example, the third point may have a coordinate of $(x_{pbc}, y_{pbc})$ and the fourth point may have a coordinate of $(x_{pca}, y_{pca})$ where:

$$x_{pbc} = \frac{x_c - y_c \cdot \sqrt{3}}{2};$$

$$y_{pbc} = \frac{y_c + x_c \cdot \sqrt{3}}{2};$$

$$x_{pca} = x_a + \frac{x_c - x_a + \sqrt{3} \cdot y_c}{2};$$

and

$$y_{pca} = \frac{(y_c - y_a) + \sqrt{3} \cdot (x_a - x_c)}{2}.$$

In one embodiment, the neutral point has a coordinate of $(x_n, y_n)$ and where:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}};$$

and

$$y_n = \frac{y_{pca}}{x_{pca}} \cdot x_n.$$

In another embodiment, the apparatus includes a meter where the meter includes the measurement module. In another embodiment, the apparatus includes a processor that executes executable code of the measurement module, the triangle module, the first line module, the second line module, the third line module, the fourth line module, and/or the line-to-neutral module.

A computer program product for determining a voltage is included. The computer program product includes a computer readable storage medium having program code embodied therein. The program code is readable/executable by a processor for measuring three line-to-line voltages for the phases in a three-phase power system, where each line-to-line voltage includes a voltage magnitude, and constructing, on a two-dimensional coordinate system with an origin, a phasor triangle with the three line-to-line voltages represented as phasors. A first phasor $V_{ab}$ originates at a first point and extends in a direction along a horizontal axis of the coordinate system to the origin. A second phasor $V_{bc}$ extends between the origin and a second point, where the second point is in a direction vertically and horizontally from the origin. A third phasor $V_{ca}$ extends between the second point and the first point.

In one embodiment, the program code is readable/executable by a processor for determining a third point by adding a first line segment that extends from a point that bisects the second phasor $V_{bc}$ in a direction perpendicular to the second phasor $V_{bc}$ and away from the phasor triangle. The first line segment terminates at the third point. In another embodiment, the program code is readable/executable by a processor for determining a fourth point by adding a second line segment that extends from a point that bisects the third phasor $V_{ca}$ in a direction perpendicular to the third phasor $V_{ca}$ and away from the phasor triangle. The second line segment terminates at the fourth point.

The program code, in one embodiment, is readable/executable by a processor for determining a neutral point by adding a third line segment from the third point to the first point and adding a fourth line segment from the fourth point to the origin, where the third line segment intersects the fourth line segment at the neutral point, and determining a line-to-neutral voltage. The line-to-neutral voltage includes a line from the neutral point to a vertex of the phasor triangle.

BRIEF DESCRIPTION OF THE DRAWINGS

In order that the advantages of the embodiments of the invention will be readily understood, a more particular description of the embodiments briefly described above will be rendered by reference to specific embodiments that are illustrated in the appended drawings. Understanding that these drawings depict only some embodiments and are not therefore to be considered to be limiting of scope, the embodiments will be described and explained with additional specificity and detail through the use of the accompanying drawings, in which:

Figure 1 is a schematic block diagram illustrating one embodiment of a system for determining voltages;
Figure 2 is a schematic block diagram illustrating one embodiment of an apparatus for determining voltages;
Figure 3 is a diagram of voltages of a three-phase power system with unbalanced voltages;
Figure 4 is a diagram of voltages of a three-phase power system with unbalanced voltages repositioned as a phasor triangle;
Figure 5 is a diagram of voltages of the three-phase power system with unbalanced voltages repositioned as a phasor triangle with perpendicular lines bisecting two sides using a first geometric method;
Figure 6 is a diagram of voltages of the three-phase power system with unbalanced voltages repositioned as a phasor triangle with perpendicular lines bisecting two sides and lines intersecting a neutral point using the first geometric method;
Figure 7 is a diagram of voltages of the three-phase power system with unbalanced voltages repositioned as a phasor triangle with line-to-neutral phasors shown from the neutral point using the first geometric method;
Figure 8 is a diagram of voltages of the three-phase power system with unbalanced voltages repositioned as a phasor triangle with perpendicular lines bisecting two sides where the length is based on an equilateral triangle using a second geometric method;
Figure 9 is a diagram of voltages of the three-phase power system with unbalanced voltages repositioned as a phasor triangle with perpendicular lines bisecting two sides and lines intersecting a neutral point using the second geometric method;
Figure 10 is a diagram of voltages of the three-phase power system with unbalanced voltages repositioned as a phasor triangle with line-to-neutral phasors shown from the neutral point using the second geometric method;
Figure 11 is a schematic flow chart diagram illustrating one embodiment of a method for determining voltages;
Figure 12A is a first part of a schematic flow chart diagram illustrating another embodiment of a method for determining voltages;
Figure 12B is second part of a schematic flow chart diagram illustrating another embodiment of a method for determining voltages;
Figure 13 is a plot of laboratory test results showing percent voltage imbalance versus reported voltage error using the first geometric method; and
Figure 14 is a plot of laboratory test results showing reported voltage error under balanced conditions using the first geometric method.

DETAILED DESCRIPTION

Reference throughout this specification to "one embodiment," "an embodiment," or similar language means that a particular feature, structure, or characteristic described in connection with the embodiment is included in at least one embodiment. Thus, appearances of the phrases "in one embodiment," "in an embodiment," and similar language throughout this specification may, but do not necessarily, all refer to the same embodiment, but mean "one or more but not all embodiments" unless expressly specified otherwise. The terms "including," "comprising," "having," and variations thereof mean "including but not limited to" unless expressly specified otherwise. An enumerated listing of items does not imply that any or all of the items are mutually exclusive and/or mutually inclusive, unless expressly specified otherwise. The terms "a," "an," and "the" also refer to "one or more" unless expressly specified otherwise.

Furthermore, the described features, advantages, and characteristics of the embodiments may be combined in any suitable manner. One skilled in the relevant art will recognize that the embodiments may be practiced without one or more of the specific features or advantages of a particular embodiment. In other instances, additional features and advantages may be recognized in certain embodiments that may not be present in all embodiments.

These features and advantages of the embodiments will become more fully apparent from the following description and appended claims, or may be learned by the practice of embodiments as set forth hereinafter. As will be appreciated by one skilled in the art, aspects of the present invention may be embodied as a system, method, and/or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module," or "system." Furthermore, aspects of the present invention may take the form of a computer program product embodied in one or more computer readable medium(s) having program code embodied thereon.

Many of the functional units described in this specification have been labeled as modules, in order to more particularly emphasize their implementation independence. For example, a module may be implemented as a hardware circuit comprising custom VLSI circuits or gate arrays, off-the-shelf semiconductors such as logic chips, transistors, or other discrete components. A module may also be implemented in programmable hardware devices such as field programmable gate arrays, programmable array logic, programmable logic devices or the like.

Modules may also be implemented in software for execution by various types of processors. An identified module of program code may, for instance, comprise one or more physical or logical blocks of computer instructions which may, for instance, be organized as an object, procedure, or function. Nevertheless, the executables of an identified module need not be physically located together, but may comprise disparate instructions stored in different locations which, when joined logically together, comprise the module and achieve the stated purpose for the module.

Indeed, a module of program code may be a single instruction, or many instructions, and may even be distributed over several different code segments, among different programs, and across several memory devices. Similarly, operational data may be identified and illustrated herein within modules, and may be embodied in any suitable form and organized within any suitable type of data structure. The operational data may be collected as a single data set, or may be distributed over different locations including over different storage devices, and may exist, at least partially, merely as electronic signals on a system or network. Where a module or portions of a module are implemented in software, the program code may be stored and/or propagated on in one or more computer readable medium(s).

The computer readable medium may be a tangible computer readable storage medium storing the program code. The computer readable storage medium may be, for example, but not limited to, an electronic, magnetic, optical, electromagnetic, infrared, holographic, micromechanical, or semiconductor system, apparatus, or device, or any suitable combination of the foregoing.

More specific examples of the computer readable storage medium may include but are not limited to a portable computer diskette, a hard disk, a random access memory ("RAM"), a read-only memory ("ROM"), an erasable programmable read-only memory ("EPROM" or Flash memory), a portable compact disc read-only memory ("CD-ROM"), a digital versatile disc ("DVD"), an optical storage device, a magnetic storage device, a holographic storage medium, a micromechanical storage device, or any suitable combination of the foregoing. In the context of this document, a computer readable storage medium may be any tangible medium that can contain, and/or store program code for use by and/or in connection with an instruction execution system, apparatus, or device.

The computer readable medium may also be a computer readable signal medium. A computer readable signal medium may include a propagated data signal with program code embodied therein, for example, in baseband or as part of a carrier wave. Such a propagated signal may take any of a variety of forms, including, but not limited to, electrical, electro-magnetic, magnetic, optical, or any suitable combination thereof. A computer readable signal medium may be any computer readable medium that is not a computer readable storage medium and that can communicate, propagate, or transport program code for use by or in connection with an instruction execution system, apparatus, or device. Program code embodied on a computer readable signal medium may be transmitted using any appropriate medium, including but not limited to wire-line, optical fiber, Radio Frequency ("RF"), or the like, or any suitable combination of the foregoing

In one embodiment, the computer readable medium may comprise a combination of one or more computer readable storage mediums and one or more computer readable signal mediums. For example, program code may be both propagated as an electro-magnetic signal through a fiber optic cable for execution by a processor and stored on RAM storage device for execution by the processor.

Program code for carrying out operations for aspects of the present invention may be written in any combination of one or more programming languages, including an object oriented programming language such as Java, Smalltalk, C++, PHP or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network ("LAN") or a wide area network ("WAN"), or the connection may be made to an external computer (for example, through the Internet using an Internet Service Provider). The computer program product may be shared, simultaneously serving multiple customers in a flexible, automated fashion.

The computer program product may be integrated into a client, server and network environment by providing for the computer program product to coexist with applications, operating systems and network operating systems software and then installing the computer program product on the clients and servers in the environment where the computer program product will function. In one embodiment software is identified on the clients and servers including the network operating system where the computer program product will be deployed that are required by the computer program product or that work in conjunction with the computer program product. This includes the network operating system that is software that enhances a basic operating system by adding networking features.

Furthermore, the described features, structures, or characteristics of the embodiments may be combined in any suitable manner. In the following description, numerous specific details are provided, such as examples of programming, software modules, user selections, network transactions, database queries, database structures, hardware modules, hardware circuits, hardware chips, etc., to provide a thorough understanding of embodiments. One skilled in the relevant art will recognize, however, that embodiments may be practiced without one or more of the specific details, or with other methods, components, materials, and so forth. In other instances, well-known structures, materials, or operations are not shown or described in detail to avoid obscuring aspects of an embodiment.

Aspects of the embodiments are described below with reference to schematic flowchart diagrams and/or schematic block diagrams of methods, apparatuses, systems, and computer program products according to embodiments of the invention. It will be understood that each block of the schematic flowchart diagrams and/or schematic block diagrams, and combinations of blocks in the schematic flowchart diagrams and/or schematic block diagrams, can be implemented by program code. The program code may be provided to a processor of a general purpose computer, special purpose computer, sequencer, or other programmable data processing apparatus to produce a machine, such that the instructions, which execute via the processor of the computer or other programmable data processing apparatus, create means for implementing the functions/acts specified in the schematic flowchart diagrams and/or schematic block diagrams block or blocks.

The program code may also be stored in a computer readable medium that can direct a computer, other programmable data processing apparatus, or other devices to function in a particular manner, such that the instructions stored in the computer readable medium produce an article of manufacture including instructions which implement the function/act specified in the schematic flowchart diagrams and/or schematic block diagrams block or blocks.

The program code may also be loaded onto a computer, other programmable data processing apparatus, or other devices to cause a series of operational steps to be performed on the computer, other programmable apparatus or other devices to produce a computer implemented process such that the program code which executed on the computer or other programmable apparatus provide processes for implementing the functions/acts specified in the flowchart and/or block diagram block or blocks.

The schematic flowchart diagrams and/or schematic block diagrams in the Figures illustrate the architecture, functionality, and operation of possible implementations of apparatuses, systems, methods and computer program products according to various embodiments of the present invention. In this regard, each block in the schematic flowchart diagrams and/or schematic block diagrams may represent a module, segment, or portion of code, which comprises one or more executable instructions of the program code for implementing the specified logical function(s).

It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. Other steps and methods may be conceived that are equivalent in function, logic, or effect to one or more blocks, or portions thereof, of the illustrated Figures.

Although various arrow types and line types may be employed in the flowchart and/or block diagrams, they are understood not to limit the scope of the corresponding embodiments. Indeed, some arrows or other connectors may be used to indicate only the logical flow of the depicted embodiment. For instance, an arrow may indicate a waiting or monitoring period of unspecified duration between enumerated steps of the depicted embodiment. It will also be noted that each block of the block diagrams and/or flowchart diagrams, and combinations of blocks in the block diagrams and/or flowchart diagrams, can be implemented by special purpose hardware-based systems that perform the specified functions or acts, or combinations of special purpose hardware and program code.

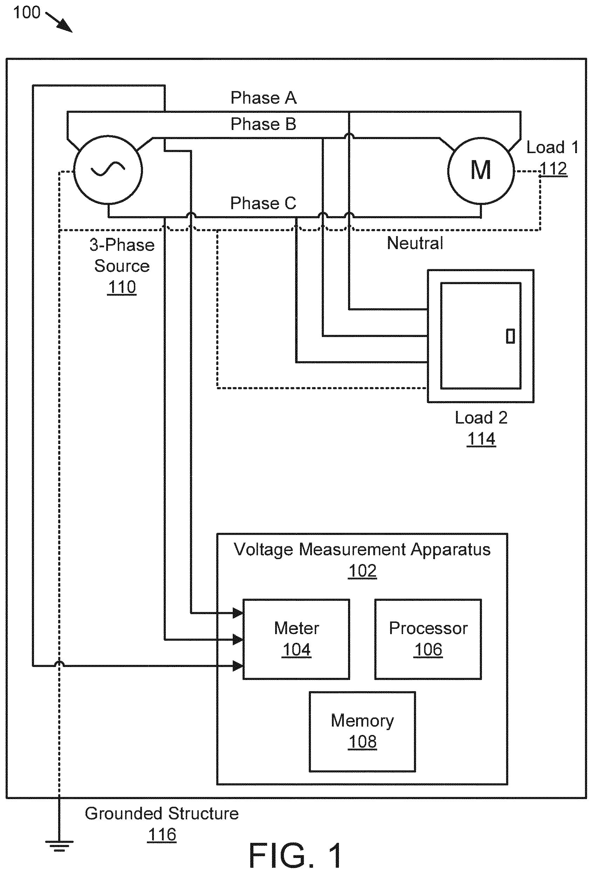

Figure 1 is a schematic block diagram illustrating one embodiment of a system 100 for determining voltages. The system 100 includes a voltage measurement apparatus 102, which in some embodiments may include a meter 104, a processor 106 and/or memory 108, a three-phase voltage source 110, a first load 112 and a second load 114 connected to the voltage source 110 with a phase A, a phase B, and a phase C, and may include a grounded structure 116, which are described below.

The system 100 includes a voltage measurement apparatus 102 that determines line-to-neutral voltages. In one embodiment, the voltage measurement apparatus 102 determines line-to-neutral voltages from line-to-line voltage of a three-phase power system, such as the system 100 depicted in Figure 1. The voltage measurement apparatus 102, in one embodiment, calculates line-to-neutral voltage where a neutral is not available. For instance, the three-phase voltage source 110 may be isolated from a grounded structure 116 and loads of the system 100 (e.g. the first and second loads 112, 114) may be three-phase loads without a neutral connection.

In one embodiment, the voltage measurement apparatus 102 includes a meter 104. The meter 104, in one example, is located with the voltage measurement apparatus 102. For example, functionality of the voltage measurement apparatus 102 may be included in the meter 104. For example, the meter 104 may be a PowerMonitor 5000™ by Allen-Bradley® and functionality of the voltage measurement apparatus 102 may be incorporated into the PowerMonitor 5000. In another embodiment, the meter 104 may be apart from the voltage measurement apparatus 102. For example, the meter 104 may measure voltages and may send voltage measurement information to the voltage measurement apparatus 102. In another embodiment, a portion of the meter 104 may be located external to the voltage measurement apparatus 102 while a portion is within the voltage measurement apparatus 102.

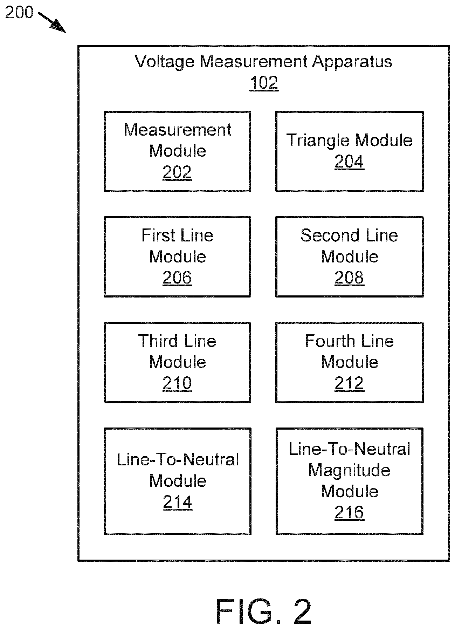

In another embodiment, the voltage measurement apparatus 102 includes a processor 106 and/or memory 108. The processor 106 may execute code associated with the voltage measurement apparatus 102. For example, the voltage measurement apparatus 102 may be embodied by computer program product for determining a voltage. The computer program product may be stored on a computer readable storage medium, such as the memory 108. The memory 108 may include RAM, ROM, a hard disk drive, etc. that has the program code embodied therein and the program code may be readable/executable by the processor 106. In another embodiment, the voltage measurement apparatus 102 is fully or partially embodied by logic hardware and may be embodied in part, in some embodiments, by executable code. Functionality of the voltage measurement apparatus 102 is explained further in the apparatus 200 of Figure 2.

The system 100, in one embodiment, includes a three-phase voltage source 110. The three-phase voltage source 110 may be three-phase power from an electric utility, may be a generator, may be an uninterruptable power supply, may be a switching power supply, or other power source that provides three-phase power. Three-phase power, in one embodiment, includes three sinusoidal voltage waveforms offset by 120 degrees. The waveforms may include a sinusoidal fundamental frequency waveform and may include harmonic waveforms. The sinusoidal fundamental frequency waveform of the three waveforms is each offset by 120 degrees.

In one embodiment, the system 100 includes one or more loads, for example the first load 112 and the second load 114. The first load 112 may be a motor, such as a three-phase motor. Often three-phase motors do not include a neutral connection and a neutral wire is not run between the three-phase voltage source 110 and the motor load 112. The second load 114 may be a branch panel. While branch panels typically include a neutral connection, in some examples a transformer (not shown) is located between the branch panel 114 and the three-phase voltage source 110 and the transformer may be a delta-wye transformer where no neutral is run upstream of the transformer. Other loads and power system configurations may also not have a neutral connection or ground connection available. In some embodiments, a grounded structure 116 or earth ground may not be available, for example for floating power systems that require isolation from ground.

Typically, the three waveforms from the three-phase voltage source 110 are balanced so that line-to-line voltages are equal and line-to-neutral voltages are equal. During this condition, determining line-to-neutral voltage from line-to-line voltage may reasonably be determined by dividing the line-to-line voltage by the square root of three. When the three voltage waveforms from the three-phase voltage source 110 or as measured at some point within the system 100 become unbalanced, determination of line-to-neutral voltage from the line-to-line voltages is not trivial. The voltage measurement apparatus 102 may be used to determine line-to-neutral voltages from line-to-line voltages.

Figure 2 is a schematic block diagram illustrating one embodiment of an apparatus 200 for determining voltages. The apparatus 200 includes a measurement module 202, a triangle module 204, a first line module 206, a second line module 208, a third line module 210, a fourth line module 212, a line-to-neutral module 214, and in some embodiments, a line-to-neutral magnitude module 216, which are described below.

The apparatus 200, in one embodiment, includes a measurement module 202 that measures three line-to-line voltages for the phases in a three-phase power system, such as the system 100 depicted in Figure 1. Each line-to-line voltage includes a voltage magnitude. For example, the line-to-line voltage magnitude may be a root-mean-square ("RMS") voltage measured between two phases. For instance the measurement module 202 may measure RMS voltages. The measurement module 202 may connect to each of the three phases A, B, and C, and a line-to-line measurement may be between Phase A and Phase B, between Phase B and Phase C, or between Phase C and Phase A. In another embodiment, the voltage magnitude may be a peak voltage. For example, the peak voltage may be a highest voltage within a cycle of a fundamental sinusoidal frequency within the three line-to-line voltages and the measurement module 202 may measure a peak voltage of the three phases, A, B, and C. The peak voltages, in another embodiment, are converted RMS voltage measurements. One example of the measurement module 202 is the meter 104 depicted in the system 100 of Figure 1.

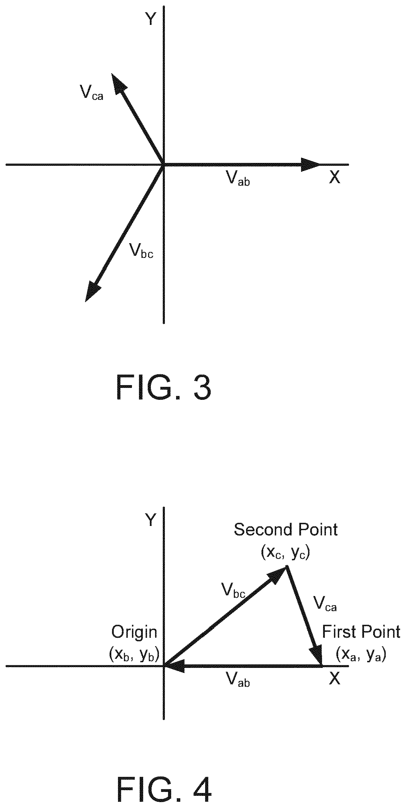

The apparatus 200, in one embodiment, includes a triangle module 204 that constructs, on a two-dimensional coordinate system with an origin, a phasor triangle that includes the three line-to-line voltages, measured by the measurement module 202, represented as phasors. A first phasor $V_{ab}$ originates at a first point and extends in a direction along a horizontal axis of the coordinate system to the origin of the coordinate system. A second phasor $V_{bc}$ extends between the origin and a second point. The second point is in a direction vertically and horizontally from the origin. A third phasor $V_{ca}$ extends between the second point and the first point. An example of a phasor triangle constructed from three line-to-line voltage phasors of Figure 3 is shown in Figure 4. In Figure 3, the third phasor $V_{ca}$ is two-thirds the voltage of the first and second phasors, $V_{ab}$ and $V_{bc}$.

Figure 3 is a diagram of voltages of a three-phase power system with unbalanced voltages. Figure 4 is a diagram of the voltages of the three-phase power system with unbalanced voltages repositioned as a phasor triangle. Figure 3 is a typical phasor diagram with phasor $V_{ab}$ oriented at zero degrees, phasor $V_{bc}$ at 120 degrees, and phasor $V_{ca}$ at -120 degrees (240 degrees) where angles are measured clockwise from the positive X axis. Note that with a voltage imbalance, angles between the voltage phasors $V_{ab}$, $V_{bc}$, and $V_{ca}$ change from the 120 degree separation in Figure 3 and angles of the phasor triangle are determined by magnitudes of the phasors. The first point is at the termination of phasor $V_{ab}$ and is $(x_a, y_a)$ so $x_a = V_{ab}$ and $y_b = 0$. The origin is $(x_b, y_b)$ so $x_b = 0$ and $y_b = 0$. The second point is $(x_c, y_c)$ and may be determined using the law of cosines, where

$$x_c = \frac{V_{ab}^2 - V_{ca}^2 + V_{bc}^2}{2 \cdot V_{ab}} \qquad\qquad \text{Equation (1)}$$

$$y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)} \qquad\qquad \text{Equation (2)}$$

$V_{ab}$, $V_{bc}$, and $V_{ca}$ are magnitudes of the three line-to-line voltages measured by the measurement module 202.

FIRST GEOMETRIC METHOD

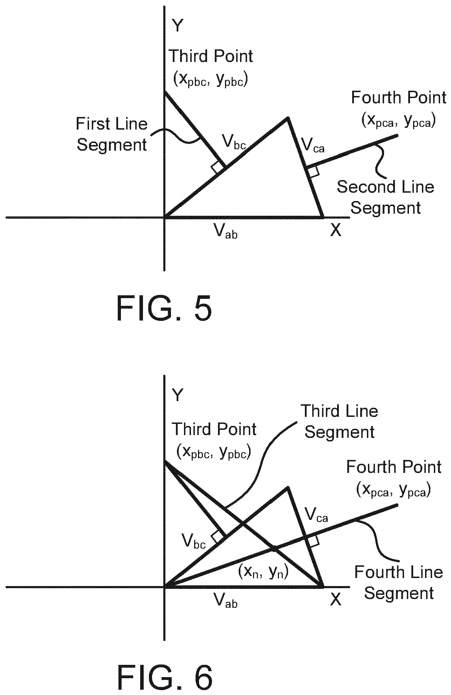

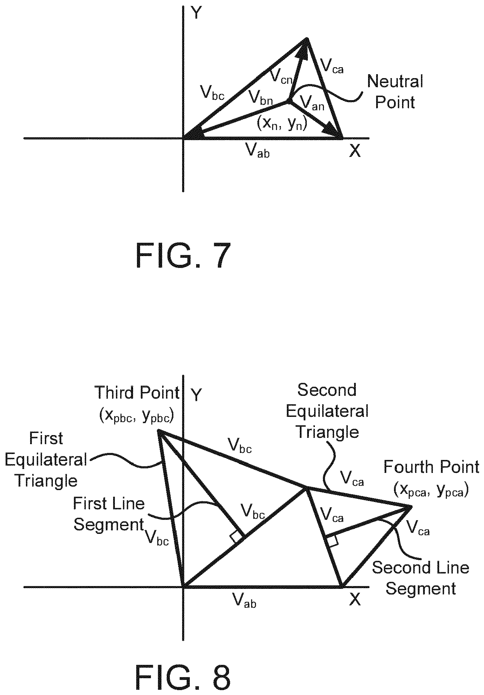

The apparatus 200, in one embodiment, includes a first line module 206 that adds a first line segment that extends from a point that bisects the second phasor $V_{bc}$ in a direction perpendicular to the second phasor $V_{bc}$ and away from the phasor triangle. The first line segment terminates at a third point. Figure 5 is a diagram of voltages of a three-phase power system with unbalanced voltages repositioned as a phasor triangle with perpendicular lines bisecting two sides using a first geometric method. Figure 5 depicts the first line segment for the first geometric method. In the embodiment, the first line segment terminates at a third point, $(x_{pbc}, y_{pbc})$. In the depicted first geometric method, the length of the first line segment has a magnitude of the third phasor $V_{ca}$ divided by the square root of three and multiplied by the square root of one plus the square of the slope of the first line segment. A second geometric method for is depicted in Figures 8-10. The slope of the first line segment may be expressed as:

$$slope_{pbc} = \frac{-x_c}{y_c} \qquad\qquad \text{Equation (3)}$$

The length of the first line segment, in one embodiment, then may be expressed as:

$$\frac{V_{ca}}{\sqrt{3}} \cdot \sqrt{1 + \left(\frac{-x_c}{y_c}\right)^2} \qquad\qquad \text{Equation (4)}$$

From the position and length of the first line segment, in one example, the third point may be determined as:

$$x_{pbc} = \frac{x_c}{2} - \frac{V_{ca}}{\sqrt{3}} \qquad\qquad \text{Equation (5)}$$

$$y_{pbc} = \frac{y_c}{2} - \frac{-x_c}{y_c} \cdot \frac{V_{ca}}{\sqrt{3}}$$ 

Equation (6)

In one embodiment, the apparatus 200 includes a second line module 208 that adds a second line segment that extends from a point that bisects the third phasor $V_{ca}$ in a direction perpendicular to the third phasor $V_{ca}$ and away from the phasor triangle. The second line segment terminates at a fourth point. Figure 5 also depicts the second line segment for the first geometric method. In the embodiment, the second line segment terminates at a fourth point, ($x_{pca}$, $y_{pca}$). In the first geometric method, the length of the second line segment has a magnitude of the second phasor $V_{bc}$ divided by the square root of three and multiplied by the square root of one plus the square of the slope of the second line segment. In one embodiment, the slope of the second line segment may be expressed as:

$$slope_{pca} = \frac{-(x_a - x_c)}{(y_a - y_c)}$$

Equation (7)

In another embodiment, the length of the second line segment then may be expressed as:

$$\frac{V_{bc}}{\sqrt{3}} \cdot \sqrt{1 + \left(\frac{-(x_a - x_c)}{(y_a - y_c)}\right)^2}$$

Equation (8)

From the position and length of the second line segment, the fourth point may be determined as:

$$x_{pca} = x_c + \frac{x_a - x_c}{2} + \frac{V_{bc}}{\sqrt{3}}$$

Equation (9)

$$y_{pca} = \frac{y_c}{2} + \frac{-(x_a - x_c)}{(y_a - y_c)} \cdot \frac{V_{bc}}{\sqrt{3}}$$

Equation (10)

The apparatus 200, in one embodiment, includes a third line module 210 that adds a third line segment from the third point to the first point and a fourth line module 212 that adds a fourth line segment from the fourth point to the origin. The third line segment intersects the fourth line segment at a neutral point, ($x_n$, $y_n$). Figure 6 is a diagram, consistent with the first geometric method, of voltages of a three-phase power system with unbalanced voltages repositioned as a phasor triangle with perpendicular lines bisecting two sides and lines intersecting a neutral point. Figure 6 depicts the neutral point ($x_n$, $y_n$). The slope of the third line segment may be expressed as:

$$slope_{3rd} = \frac{-y_{pbc}}{x_a - x_{pbc}}$$

Equation (11)

An equation for the third line segment is y = slope$_{3rd}$·x + Z where Z = -slope$_{3rd}$· $x_a$. The slope of the fourth line segment may be expressed as:

$$slope_{4th} = \frac{y_{pca}}{x_{pca}}$$

Equation (12)

An equation for the fourth line segment is y = slope$_{4th}$·x. The x-coordinate of the intersection of the third and fourth lines segments may be expressed as:

$$x_n = \frac{Z}{slope_{4th} - slope_{3rd}}$$

Equation (13)

The y-coordinate of the intersection of the third and fourth line segments may be expressed as:

$$y_n = slope_{4th} \cdot x_n \qquad \text{Equation (14)}$$

The neutral point $(x_n, y_n)$, in one embodiment, may then be expressed as:

$$x_n = \cfrac{\cfrac{y_{pbc}}{x_a - x_{pbc}} \cdot x_a}{\cfrac{y_{pca}}{x_{pca}} + \cfrac{y_{pbc}}{x_a - x_{pbc}}} \qquad \text{Equation (15)}$$

$$y_n = \frac{y_{pca}}{x_{pca}} \cdot x_n \qquad \text{Equation (16)}$$

The apparatus 200, in one embodiment, includes a line-to-neutral module 214 that determines a line-to-neutral voltage where the line-to-neutral voltage is a line from the neutral point to a vertex of the phasor triangle. In one embodiment, the line-to-neutral module 214 determines the line-to-neutral voltage for a phasor $V_{an}$ for phase A, which includes determining a line from the neutral point to the first point. In another embodiment, the line-to-neutral module 214 determines the line-to-neutral voltage for a phasor $V_{bn}$ for phase B, which includes determining a line from the neutral point to the origin. In another embodiment, the line-to-neutral module 214 determines the line-to-neutral voltage for a phasor $V_{cn}$ for phase C, which includes determining a line from the neutral point to the second point.

Figure 7 is a diagram of voltages of a three-phase power system with unbalanced voltages repositioned as a phasor triangle with line-to-neutral phasors shown from the neutral point. Figure 7 depicts the phasor $V_{an}$ for phase A, the phasor $V_{bn}$ for phase B, and the phasor $V_{cn}$ for phase C. In one embodiment, the apparatus 200 includes a line-to-neutral magnitude module 216 that determines a magnitude of the line-to-neutral voltage phasors. In one embodiment, the line-to-neutral magnitude module 216 determines magnitudes of the line-to-neutral phasors as:

$$V_{an} = \sqrt{(x_a - x_n)^2 + (y_a - y_n)^2} \qquad \text{Equation (17)}$$

$$V_{bn} = \sqrt{(x_b - x_n)^2 + (y_b - y_n)^2} \qquad \text{Equation (18)}$$

$$V_{cn} = \sqrt{(x_c - x_n)^2 + (y_c - y_n)^2} \qquad \text{Equation (19)}$$

The equations listed above may be less computationally intensive than other methods of calculating line-to-neutral voltages from line-to-line voltages. For example, the equations do not use sine or cosine functions.

In some embodiments, certain extreme voltage imbalance may cause the neutral point to be outside the phasor triangle. For example, in the case of a phase loss, the neutral point may be slightly outside the phasor triangle. For instance, as certain equations have a denominator that approaches zero, the equations may calculate a neutral point outside the phasor triangle. To correct for these situations, in one embodiment the following equations may be used to correct the neutral point location:

$$y_n := \text{if } y_n < 0 \text{ then } y_n = 0; \text{ else if } y_n > y_c, \text{then } y_n \\ = y_c; \text{ else } y_n. \qquad \text{Equation (20)}$$

$$x_n := if\, x_n < 0 \text{ then } x_n = 0; \text{ else if } x_n > x_a \text{ then } x_n \\ = x_a; \text{ else if } y_c = y_a \text{ then } x_n = x_c; \text{ else } x_n \\ = x_n. \qquad \text{Equation (21)}$$

SECOND GEOMETRIC METHOD

For the second geometric method, the first line module 206 again adds a first line segment that extends from a point that bisects the second phasor $V_{bc}$ in a direction perpendicular to the second phasor $V_{bc}$ and away from the phasor triangle and the first line segment terminates at a third point. However, the third point, $(x_{pbc}, y_{pbc})$ terminates at a point that is a vertex of a first equilateral triangle formed along the second phasor $V_{bc}$ and away from the phasor triangle where the three sides of the equilateral triangle all have a length of the magnitude of the second phasor $V_{bc}$. The length of the first line segment is the magnitude of the second phasor $V_{bc}$ multiplied by the square root of three and divided by two.

Also for the second geometric method, the second line module 208 again adds a second line segment that extends from a point that bisects the second phasor $V_{bc}$ in a direction perpendicular to the third phasor $V_{ca}$ and away from the phasor triangle and the second line segment terminates at a fourth point. However, the fourth point, , $(x_{pca}, y_{pca})$ terminates at a point that is a vertex of a second equilateral triangle formed along the third phasor $V_{ca}$ and away from the phasor triangle where the three sides of the equilateral triangle all have a length of the magnitude of the third phasor $V_{ca}$. The length of the second line segment is the magnitude of the third phasor $V_{ca}$ multiplied by the square root of three and divided by two. Figure 8 depicts the first and second equilateral triangles. The first equilateral triangle has sides equal to the second phasor $V_{bc}$. The second equilateral triangle has sides equal to the third phasor $V_{ca}$. The first line segment terminates at the third point at a vertex of the first equilateral triangle and the second line segment terminates at the fourth point at a vertex of the second equilateral triangle.

The slope of the first line segment is the same as stated above in Equation 3. Also, the slope of the second line segment is as stated above in Equation 7. From the position and length of the first line segment, in one example, the third point and the fourth point may be determined as:

$$x_{pbc} = \frac{x_c - y_c \cdot \sqrt{3}}{2} \qquad \text{Equation (22)}$$

$$y_{pbc} = \frac{y_c + x_c \cdot \sqrt{3}}{2} \qquad \text{Equation (23)}$$

$$x_{pca} = x_a + \frac{x_c - x_a + \sqrt{3} \cdot y_c}{2} \qquad \text{Equation (24)}$$

$$y_{pca} = \frac{(y_c - y_a) + \sqrt{3} \cdot (x_a - x_c)}{2} \qquad \text{Equation (25)}$$

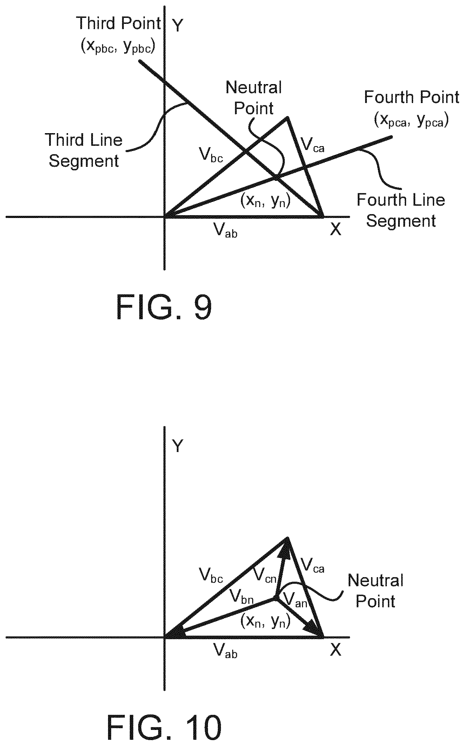

Again, the third line module 210 adds a third line segment from the third point to the first point and the fourth line module 212 adds a fourth line segment from the fourth point to the origin. The third line segment again intersects the fourth line segment at a neutral point, $(x_n, y_n)$. Consistent with the second geometric method, Figure 9 is a diagram of voltages of a three-phase power system with unbalanced voltages repositioned as a phasor triangle with perpendicular lines bisecting two sides and lines intersecting a neutral point. Figure 9 again depicts the neutral point $(x_n, y_n)$. The slope of the third line segment may be expressed as stated above in Equation 11. An equation for the third line segment is $y = \text{slope}_{3rd} \cdot x + Z$ where $Z = -\text{slope}_{3rd} \cdot x_a$. The slope of the fourth line segment may be expressed as stated above in Equation 12. An equation for the fourth line segment is $y = \text{slope}_{4th} \cdot x$. The x-coordinate of the intersection of the third and fourth lines segments may be expressed as stated above in Equation 13. The y-coordinate of the intersection of the third and fourth line segments may be expressed as stated above in Equation 14.

The neutral point $(x_n, y_n)$, in one embodiment, may then be expressed as:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}} \qquad \text{Equation (26)}$$

$$y_n = \frac{y_{pca}}{x_{pca}} \cdot x_n \hspace{4cm} \text{Equation (27)}$$

The neutral point may be called the isogonic center, which is a point inside of a triangle where no interior angle is greater than 120 degrees and where an observer would see the vertices at equal degree distances, e.g. 120 degrees apart. Typically the neutral point for the second geometric method remains within the phasor triangle and the line-to-neutral voltages are at a constant 120 degrees apart typically due to machine geometry. However, machine error may cause variations, for example when denominators are small. The line-to-neutral module 214 again determines a line-to-neutral voltage where the line-to-neutral voltage is a line from the neutral point to a vertex of the phasor triangle. In one embodiment, the line-to-neutral module 214 determines the line-to-neutral voltage for a phasor $V_{an}$ for phase A, which includes determining a line from the neutral point to the first point. In another embodiment, the line-to-neutral module 214 determines the line-to-neutral voltage for a phasor $V_{bn}$ for phase B, which includes determining a line from the neutral point to the origin. In another embodiment, the line-to-neutral module 214 determines the line-to-neutral voltage for a phasor $V_{cn}$ for phase C, which includes determining a line from the neutral point to the second point.

Consistent with the second geometric method, Figure 10 is a diagram of voltages of a three-phase power system with unbalanced voltages repositioned as a phasor triangle with line-to-neutral phasors shown from the neutral point. Figure 10 depicts the phasor $V_{an}$ for phase A, the phasor $V_{bn}$ for phase B, and the phasor $V_{cn}$ for phase C. The line-to-neutral magnitude module 216 determines a magnitude of the line-to-neutral voltage phasors. The line-to-neutral magnitude module 216 determines magnitudes of the line-to-neutral phasors as stated above in Equations 17, 18 and 19.

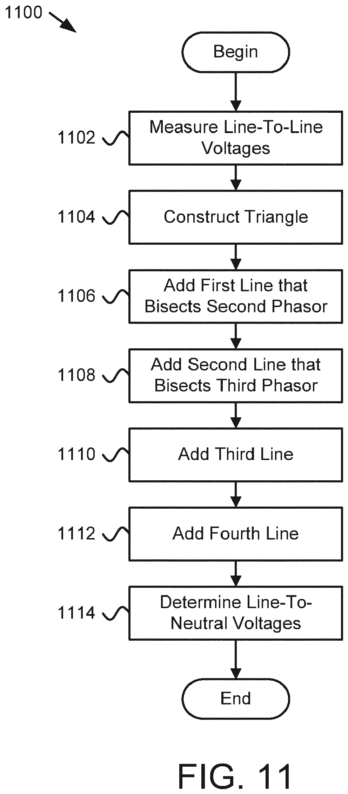

Figure 11 is a schematic flow chart diagram illustrating one embodiment of a method 1100 for determining voltages. The method 1100 begins and measures 1102 three line-to-line voltages for the phases in a three-phase power system, such as the system 100 depicted in Figure 1. Each line-to-line voltage includes a voltage magnitude. In one embodiment, the measurement module 202 measures the three line-to-line voltages.

The method 1100 constructs 1104, on a two-dimensional coordinate system with an origin, a phasor triangle with the three line-to-line voltages represented as phasors, where a first phasor $V_{ab}$ originates at a first point and extends in a direction along a horizontal axis of the coordinate system to the origin, a second phasor $V_{bc}$ extends between the origin and a second point, the second point in a direction vertically and horizontally from the origin, and a third phasor $V_{ca}$ extends between the second point and the first point. In one embodiment, the triangle module 204 constructs the phasor triangle.

The method 1100 adds 1106 a first line segment that extends from a point that bisects the second phasor $V_{bc}$ in a direction perpendicular to the second phasor $V_{bc}$ and away from the phasor triangle. The first line segment terminates at a third point. For the first geometric method, the length of the first line segment has a magnitude of the third phasor $V_{ca}$ divided by the square root of three and multiplied by the square root of one plus the square of the slope of the first line segment. For the second geometric method, the length of the first line segment is the magnitude of the second phasor $V_{bc}$ multiplied by the square root of three and divided by two. The first line module 206, in one embodiment, adds 1106 the first line segment.

The method 1100 adds 1108 a second line segment that extends from a point that bisects the third phasor $V_{ca}$ in a direction perpendicular to the third phasor $V_{ca}$ and away from the phasor triangle. The second line segment terminates at a fourth point. For the first geometric method, the length of the second line segment has a magnitude of the second phasor $V_{bc}$ divided by the square root of three and multiplied by the square root of one plus the square of the slope of the second line segment. For the second geometric method, the length of the second line segment is the magnitude of the third phasor $V_{ca}$ multiplied by the square root of three and divided by two. The second line module 208, in one example, adds 1108 the second line segment.

The method 1100 adds 1110 a third line segment from the third point to the first point and adds 1112 a fourth line segment from the fourth point to the origin. The third line segment intersects the fourth line segment at a neutral point. In one embodiment, the third line module 210 adds 1110 the third line segment and the fourth line module 212 adds 1112 the fourth line segment. The method 1100 determines 1114 a line-to-neutral voltage where the line-to-neutral voltage is a line from the neutral point to a vertex of the phasor triangle, and the method 1100 ends. The line-to-neutral module 214, in one embodiment, determines 1114 the line-to-neutral voltages.

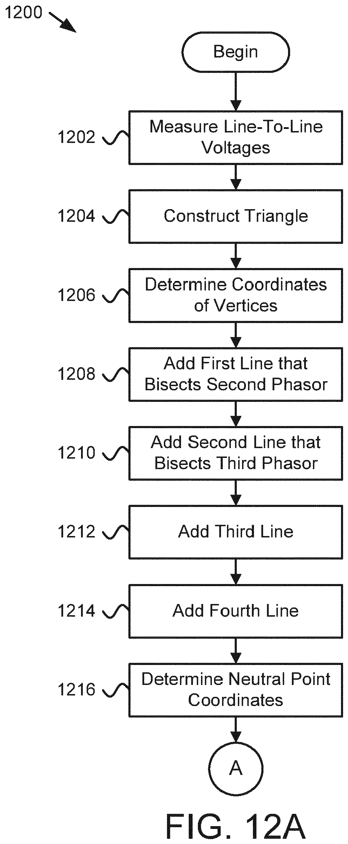

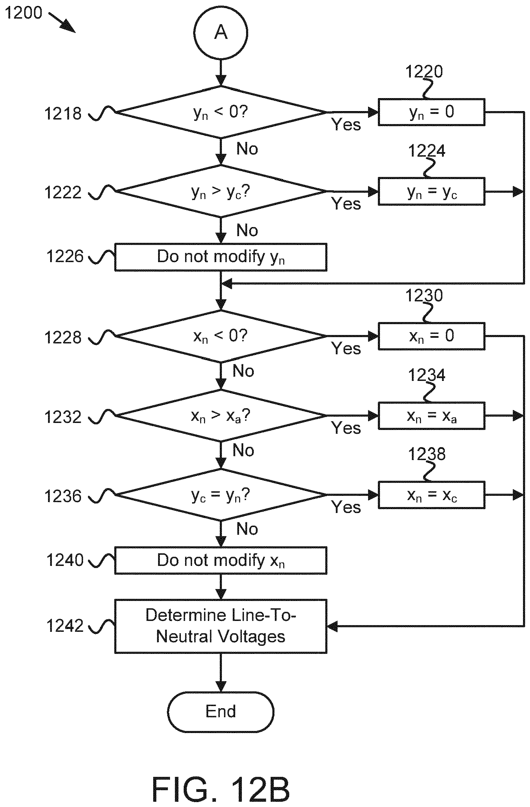

Figure 12A is a first part and Figure 12B is a second part of a schematic flow chart diagram illustrating another embodiment of a method 1200 for determining voltages. The method 1200 begins and measures 1202 three line-to-line voltages for the phases in a three-phase power system, such as the system 100 depicted in Figure 1. Each line-to-line voltage includes a voltage magnitude. The method 1200 constructs 1204, on a two-dimensional coordinate system with an origin, a phasor triangle with the three line-to-line voltages represented as phasors, where a first phasor $V_{ab}$ originates at a first point and extends in a direction along a horizontal axis of the coordinate system to the origin, a second phasor $V_{bc}$ extends between the origin and a second point, the second point in a direction vertically and horizontally from the origin, and a third phasor $V_{ca}$ extends between the second point and the first point.

The method 1200 determines 1206 coordinates of the vertices of the phasor triangle. For example, the method 1200 may determine 1206 that the first point is at the termination of phasor $V_{ab}$ and is $(x_a, y_a)$ so $x_a = V_{ab}$ and $y_b = 0$. The origin is $(x_b, y_b)$ so the method 1200 may determine 1206 that $x_b = 0$ and $y_b = 0$. The method 1200 may determine 1206 the second point $(x_c, y_c)$ using equations 1 and 2.

The method 1200 adds 1208 a first line segment that extends from a point that bisects the second phasor $V_{bc}$ in a direction perpendicular to the second phasor $V_{bc}$ and away from the phasor triangle. The first line segment terminates at a third point. For the first geometric method, the length of the first line segment has a magnitude of the third phasor $V_{ca}$ divided by the square root of three and multiplied by the square root of one plus the square of the slope of the first line segment. For the second geometric method, the length of the first line segment is the magnitude of the second phasor $V_{bc}$ multiplied by the square root of three and divided by two. The method 1200 adds 1210 a second line segment that extends from a point that bisects the third phasor $V_{ca}$ in a direction perpendicular to the third phasor $V_{ca}$ and away from the phasor triangle. The second line segment terminates at a fourth point. For the first geometric method, the length of the second line segment has a magnitude of the second phasor $V_{bc}$ divided by the square root of three and multiplied by the square root of one plus the square of the slope of the second line segment. For the second geometric method, the length of the second line segment is the magnitude of the third phasor $V_{ca}$ multiplied by the square root of three and divided by two.

The method 1200 adds 1212 a third line segment from the third point to the first point and adds 1214 a fourth line segment from the fourth point to the origin. The third line segment intersects the fourth line segment at a neutral point. The method 1200 determines 1216 coordinates of a neutral point $(x_n, y_n)$. Theoretically, steps 1218-1240 are be more applicable to the first geometric method than the second geometric method for voltages greater than zero. However, calculation error and possible negative voltage readings are possible so steps 1218-1240 may be used for both the first and the second geometric methods. The method 1200 determines 1218 if $y_n < 0$ (follow "A" on Figure 12A to "A" on Figure 12B). If the method 1200 determines that $y_n$ is less than zero, the method 1200 then assigns 1220 $y_n$ to be equal to zero. If the method 1200 determines 1218 that $y_n$ is not less than zero, then the method 1200 determines 1222 if $y_n$ is greater than $y_c$. If the method 1200 determines 1222 that $y_n$ is greater than $y_c$, then the method 1200 assigns 1224 $y_n$ to be equal to $y_c$. If the method 1200 determines 1222 that $y_n$ is not greater than $y_c$, the method 1200 determines 1226 that $y_n$ is not to be modified. For example, the method 1200 may use the results of equation 17 to determine $y_n$ without further modification.

The method 1200 determines 1228 if $x_n$ is less than zero. If the method 1200 determines 1228 if $x_n$ is less than zero, the method assigns 1230 $x_n$ to be equal to zero. If the method 1200 determines 1228 that $x_n$ is not less than zero, the method 1200 determines 1232 if $x_n$ is greater than $x_a$. If the method 1200 determines 1232 that $x_n$ is greater than $x_a$, the method 1200 assigns 1234 $x_n$ to be equal to $x_a$. If the method 1200 determines 1232 that $x_n$ is not greater than $x_a$, the method 1200 determines 1236 if $y_c$ is greater than $y_n$. If the method 1200 determines 1236 that $y_c$ is greater than $y_n$, the method 1200 assigns 1238 $x_n$ to be equal to $x_c$. If the method 1200 determines 1236 that $y_c$ is not greater than $y_n$, the method 1200 determines 1240 that $x_n$ is not to be modified. For example, the method 1200 may use the results of equation 16 to determine $x_n$ without further modification. The method 1200 determines 1242 a line-to-neutral voltage where the line-to-neutral voltage is a line from the neutral point to a vertex of the phasor triangle, and the method 1200 ends.

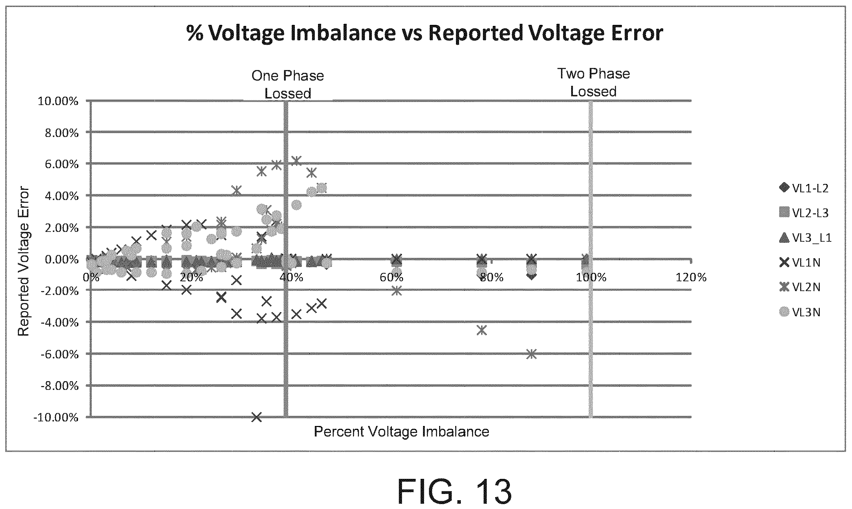

Figure 13 is a plot of laboratory test results showing percent voltage imbalance versus reported voltage error for the first geometric method. Testing was completed using an apparatus similar to the apparatus 200 of Figure 2 tested on a simple three-phase power system, which may be similar to the system 100 of Figure 1. Data for Figure 13 is shown in Table 1 and Table 2. Table 1 includes in the first three columns line-to-neutral voltage settings on the test equipment. The voltage settings vary on each phase between zero and 400 volts and represent various under and over-voltage conditions for three phases, 1, 2 and 3. The next three columns are expected line-to-line voltage conditions based on the test equipment settings. The next three columns are reported line-to-line voltages, which are reported from the metering device. The reported line-to-neutral voltages are the voltages calculated by the metering device using one embodiment of the apparatus 200 and methods 1100, 1200 described above in relation to Figures 2, 11, and 12. The calculated percent voltage imbalance of the second to last column is based on the test equipment set voltages and the reported percent voltage imbalance of the last column is the voltage imbalance reported by the metering device. The first three columns of Table 2 show reported line-to-line voltage error from expected line-to-line voltages as reported from the metering device. The last three columns of Table 2 show reported line-to-neutral voltage error comparing reported line-to-neutral voltages from the metering to the set line-to-neutral voltages.

Figure 13 is a plot of the results in Table 2. Figure 13 has percent voltage imbalance is shown on the horizontal axis and reported voltage error is shown on the vertical axis. VL1-L2 is the line-to-line voltage between a first and a second phase, VL2-L3 is the line-to-line voltage between the second and a third phase, and VL3-L1 is the line-to-line voltage between the third and the first phase. VL1N, VL2N and VL3N are line-to-neutral voltages for the first, second, and third phases, respectively. The "One Phase Lossed" line indicates a percent voltage imbalance corresponding to one phase of the 3-phase power system being shorted to ground and the "Two Phase Lossed" line indicated a percent voltage imbalance corresponding to when two phases are shorted to ground. Note that reported voltage error is greatest for when voltage approaches zero for one phase, but the error in most situations remains low. Two single phase loss conditions are represented in the graph. In one instance, the first phase (e.g. Phase A in the system 100 of Figure 1) is reduced to zero, and in the second instance the second phase (e.g. Phase B in the system 100 of Figure 1) is reduced to zero.

**Table 1**

| Set L-N V | | | Expected L-L V | | | Reported L-L V | | | Reported L-N V | | | Calc. % V Imbal. | Reported % V Imbal |
|---|---|---|---|---|---|---|---|---|---|---|---|---|---|
| L1N | L2N | L3N | L12 | L23 | L31 | L12 | L23 | L31 | L1N | L2N | L3N | | |
| 400 | 400 | 0 | 693 | 400 | 400 | 692 | 399 | 400 | 400 | 398 | 0 | 39% | 39% |
| 400 | 400 | 20 | 693 | 410 | 410 | 692 | 409 | 410 | 410 | 409 | 0 | 37% | 37% |
| 400 | 400 | 50 | 693 | 427 | 427 | 692 | 426 | 427 | 406 | 405 | 37 | 34% | 34% |
| 400 | 400 | 400 | 693 | 693 | 693 | 692 | 692 | 691 | 399 | 400 | 398 | 0% | 0% |
| 400 | 400 | 375 | 693 | 671 | 671 | 692 | 670 | 670 | 399 | 399 | 375 | 2% | 2% |
| 400 | 400 | 350 | 693 | 650 | 650 | 692 | 649 | 649 | 399 | 399 | 351 | 4% | 4% |
| 400 | 400 | 325 | 693 | 629 | 629 | 692 | 628 | 628 | 398 | 398 | 327 | 7% | 7% |
| 400 | 400 | 300 | 693 | 608 | 608 | 692 | 607 | 607 | 398 | 398 | 302 | 9% | 9% |
| 400 | 400 | 240 | 693 | 560 | 560 | 692 | 559 | 559 | 397 | 397 | 244 | 15% | 15% |
| 400 | 400 | 200 | 693 | 529 | 529 | 692 | 528 | 528 | 397 | 397 | 203 | 19% | 19% |
| 400 | 400 | 180 | 693 | 514 | 514 | 692 | 513 | 513 | 397 | 397 | 184 | 21% | 21% |
| 400 | 400 | 150 | 693 | 492 | 492 | 692 | 492 | 492 | 398 | 398 | 152 | 24% | 24% |
| 400 | 400 | 130 | 693 | 478 | 478 | 692 | 478 | 478 | 399 | 399 | 130 | 26% | 26% |
| 400 | 400 | 120 | 693 | 472 | 472 | 692 | 471 | 471 | 399 | 399 | 120 | 27% | 27% |
| 400 | 300 | 120 | 608 | 375 | 472 | 608 | 374 | 471 | 390 | 307 | 122 | 26% | 26% |
| 400 | 240 | 120 | 560 | 317 | 472 | 559 | 317 | 471 | 386 | 250 | 122 | 29% | 29% |
| 400 | 200 | 120 | 529 | 280 | 472 | 529 | 280 | 471 | 385 | 211 | 124 | 34% | 34% |
| 400 | 180 | 120 | 514 | 262 | 472 | 514 | 261 | 471 | 385 | 191 | 123 | 37% | 37% |
| 400 | 150 | 120 | 492 | 234 | 472 | 492 | 234 | 471 | 386 | 159 | 124 | 41% | 41% |
| 400 | 130 | 120 | 478 | 217 | 472 | 478 | 216 | 471 | 388 | 137 | 125 | 44% | 44% |
| 400 | 120 | 120 | 472 | 208 | 472 | 471 | 208 | 471 | 389 | 125 | 125 | 46% | 46% |
| 300 | 120 | 120 | 375 | 208 | 375 | 374 | 208 | 374 | 292 | 124 | 123 | 35% | 35% |
| 240 | 120 | 120 | 317 | 208 | 317 | 317 | 208 | 317 | 234 | 123 | 122 | 26% | 26% |
| 200 | 120 | 120 | 280 | 208 | 280 | 280 | 208 | 280 | 196 | 122 | 121 | 19% | 19% |
| 180 | 120 | 120 | 262 | 208 | 262 | 261 | 208 | 261 | 177 | 121 | 121 | 15% | 15% |
| 150 | 120 | 120 | 234 | 208 | 234 | 234 | 208 | 234 | 148 | 121 | 120 | 8% | 8% |
| 130 | 120 | 120 | 217 | 208 | 217 | 216 | 208 | 216 | 129 | 120 | 120 | 3% | 3% |
| 120 | 120 | 120 | 208 | 208 | 208 | 208 | 208 | 208 | 120 | 120 | 120 | 0% | 0% |
| 115 | 120 | 120 | 204 | 208 | 204 | 203 | 208 | 203 | 115 | 120 | 119 | 1% | 1% |
| 110 | 120 | 120 | 199 | 208 | 199 | 199 | 208 | 199 | 110 | 120 | 119 | 3% | 3% |
| 105 | 120 | 120 | 195 | 208 | 195 | 195 | 208 | 195 | 105 | 120 | 119 | 4% | 4% |
| 100 | 120 | 120 | 191 | 208 | 191 | 191 | 208 | 190 | 101 | 119 | 119 | 6% | 6% |
| 90 | 120 | 120 | 182 | 208 | 182 | 182 | 208 | 182 | 91 | 119 | 119 | 9% | 9% |
| 80 | 120 | 120 | 174 | 208 | 174 | 174 | 208 | 174 | 81 | 119 | 119 | 12% | 12% |

(continued)

| Set L-N V | | | Expected L-L V | | | Reported L-L V | | | Reported L-N V | | | | |
|---|---|---|---|---|---|---|---|---|---|---|---|---|---|
| L1N | L2N | L3N | L12 | L23 | L31 | L12 | L23 | L31 | L1N | L2N | L3N | Calc. % V Imbal. | Reported % V Imbal |
| 70 | 120 | 120 | 166 | 208 | 166 | 166 | 208 | 166 | 71 | 119 | 119 | 15% | 15% |
| 60 | 120 | 120 | 159 | 208 | 159 | 159 | 208 | 159 | 61 | 119 | 119 | 19% | 19% |
| 50 | 120 | 120 | 151 | 208 | 151 | 151 | 208 | 151 | 51 | 119 | 119 | 22% | 22% |
| 40 | 120 | 120 | 144 | 208 | 144 | 144 | 208 | 144 | 41 | 119 | 119 | 26% | 26% |
| 30 | 120 | 120 | 137 | 208 | 137 | 137 | 208 | 137 | 30 | 120 | 120 | 29% | 29% |
| 20 | 120 | 120 | 131 | 208 | 131 | 131 | 208 | 131 | 18 | 121 | 121 | 33% | 33% |
| 10 | 120 | 120 | 125 | 208 | 125 | 125 | 208 | 125 | 5.2 | 122 | 122 | 36% | 36% |
| 5 | 120 | 120 | 123 | 208 | 123 | 123 | 208 | 123 | 0 | 123 | 122 | 38% | 38% |
| 0 | 120 | 120 | 120 | 208 | 120 | 120 | 208 | 120 | 0 | 120 | 120 | 39% | 39% |
| 0 | 110 | 120 | 110 | 199 | 120 | 110 | 199 | 120 | 0 | 110 | 120 | 39% | 39% |
| 0 | 100 | 120 | 100 | 191 | 120 | 100 | 191 | 120 | 0 | 100 | 120 | 39% | 39% |
| 0 | 80 | 120 | 80 | 174 | 120 | 80 | 174 | 120 | 0 | 80 | 120 | 40% | 40% |
| 0 | 60 | 120 | 60 | 159 | 120 | 60 | 159 | 120 | 0 | 60 | 120 | 47% | 47% |
| 0 | 40 | 120 | 40 | 144 | 120 | 40 | 144 | 120 | 1.2 | 39 | 119 | 61% | 61% |
| 0 | 20 | 120 | 20 | 131 | 120 | 20 | 131 | 120 | 1.7 | 19 | 119 | 78% | 78% |
| 0 | 10 | 120 | 10 | 125 | 120 | 9.9 | 125 | 120 | 1.2 | 9.4 | 119 | 88% | 88% |
| 0 | 0 | 120 | 0 | 120 | 120 | 0.9 | 120 | 120 | 0.8 | 0.1 | 119 | 99% | 99% |

**Table 2**

| Reported Line-to-Line Voltage Error From Expected Value | | | Reported Line-to-Neutral Voltage Error | | |
|---|---|---|---|---|---|
| VL1-L2 | VL2-L3 | VL3_L1 | VL1N | VL2N | VL3N |
| -0.10% | -0.32% | -0.05% | -0.13% | 0.42% | 0.42% |
| -0.09% | -0.28% | -0.09% | 2.43% | 2.22% | 100.00% |
| -0.08% | -0.28% | -0.09% | 1.43% | 1.28% | -26.00% |
| -0.10% | -0.13% | -0.21% | -0.17% | 0.05% | -0.40% |
| -0.08% | -0.13% | -0.18% | -0.28% | 0.22% | -0.13% |
| -0.08% | -0.15% | -0.20% | -0.38% | 0.33% | 0.26% |
| -0.09% | -0.16% | -0.19% | -0.47% | 0.42% | 0.52% |
| -0.10% | -0.14% | -0.19% | -0.60% | 0.53% | 0.67% |
| -0.09% | -0.13% | -0.18% | -0.75% | 0.70% | 1.67% |
| -0.10% | -0.16% | -0.16% | -0.72% | 0.72% | 1.60% |
| -0.08% | -0.16% | -0.17% | -0.65% | 0.70% | 2.06% |
| -0.12% | -0.19% | -0.19% | -0.53% | 0.53% | 1.27% |
| -0.09% | -0.20% | -0.15% | -0.30% | 0.35% | 0.31% |
| -0.09% | -0.21% | -0.15% | -0.22% | 0.25% | 0.25% |
| -0.08% | -0.19% | -0.15% | -2.45% | 2.37% | 1.58% |

(continued)

| Reported Line-to-Line Voltage Error From Expected Value | | | Reported Line-to-Neutral Voltage Error | | |
|---|---|---|---|---|---|
| VL1-L2 | VL2-L3 | VL3_L1 | VL1N | VL2N | VL3N |
| -0.11% | -0.15% | -0.17% | -3.45% | 4.33% | 1.75% |
| -0.09% | -0.14% | -0.15% | -3.75% | 5.55% | 3.17% |
| -0.12% | -0.17% | -0.15% | -3.68% | 5.94% | 2.75% |
| -0.11% | -0.13% | -0.15% | -3.47% | 6.20% | 3.42% |
| -0.11% | -0.17% | -0.15% | -3.10% | 5.46% | 4.25% |
| -0.10% | -0.12% | -0.10% | -2.80% | 4.50% | 4.50% |
| -0.11% | -0.12% | -0.19% | -2.67% | 3.08% | 2.50% |
| -0.12% | -0.12% | -0.15% | -2.38% | 2.17% | 1.67% |
| -0.11% | -0.17% | -0.18% | -1.95% | 1.42% | 0.83% |
| -0.05% | -0.17% | -0.20% | -1.67% | 1.08% | 0.67% |
| -0.09% | -0.12% | -0.22% | -1.07% | 0.50% | 0.25% |
| -0.08% | -0.07% | -0.17% | -0.62% | 0.08% | -0.08% |
| -0.07% | -0.07% | -0.17% | -0.17% | 0.08% | -0.33% |
| -0.06% | -0.12% | -0.16% | 0.00% | 0.17% | -0.83% |
| -0.07% | -0.17% | -0.17% | 0.18% | 0.33% | -0.67% |
| -0.10% | -0.17% | -0.15% | 0.38% | 0.42% | -0.67% |
| -0.10% | -0.12% | -0.20% | 0.60% | 0.50% | -0.83% |
| -0.10% | -0.12% | -0.16% | 1.11% | 0.58% | -0.83% |
| -0.09% | -0.12% | -0.20% | 1.50% | 0.67% | -0.83% |
| -0.08% | -0.12% | -0.14% | 1.86% | 0.75% | -0.92% |
| -0.09% | -0.07% | -0.15% | 2.17% | 0.67% | -0.92% |
| -0.15% | -0.12% | -0.15% | 2.20% | 0.67% | -0.75% |
| -0.08% | -0.12% | -0.08% | 1.50% | 0.50% | -0.50% |
| -0.06% | -0.17% | -0.06% | -1.33% | 0.08% | -0.25% |
| -0.04% | -0.12% | -0.04% | -10.00% | 0.67% | 0.67% |
| -0.08% | -0.07% | 0.08% | -48.00% | 1.83% | 1.75% |
| -0.06% | -0.07% | 0.02% | 100.00% | 2.08% | 1.92% |
| -0.25% | -0.07% | 0.00% | - | 0.17% | -0.25% |
| -0.18% | -0.12% | 0.00% | - | 0.18% | -0.25% |
| -0.20% | -0.10% | 0.00% | - | 0.20% | -0.25% |
| -0.25% | -0.09% | 0.00% | - | 0.25% | -0.25% |
| -0.33% | -0.15% | 0.00% | - | 0.17% | -0.25% |
| -0.25% | -0.15% | 0.00% | - | 2.00% | -0.83% |
| -1.00% | -0.19% | 0.00% | - | 4.50% | -0.83% |
| -1.00% | -0.24% | 0.00% | - | 6.00% | -0.67% |
| - | -0.33% | 0.00% | - | - | -0.83% |

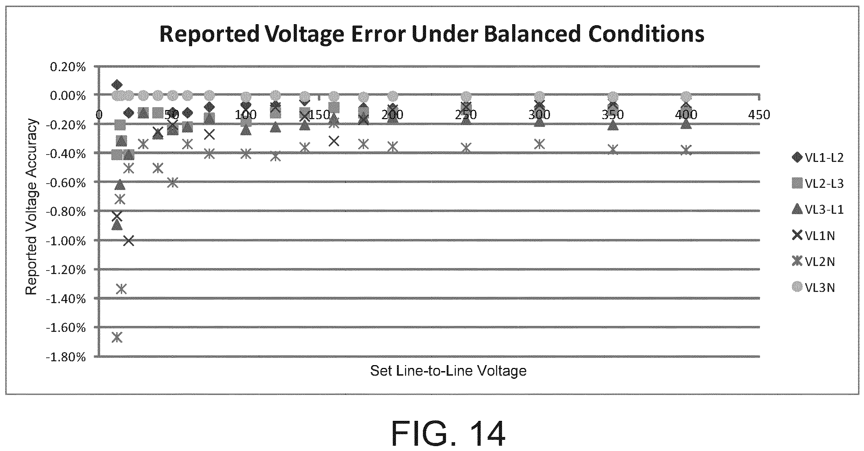

Figure 14 is a plot of laboratory test results showing reported voltage error under balanced conditions using the first geometric method. The apparatus and three-phase power system used for the results shown in Figure 13 were again used for testing. In this particular test, line-to-neutral voltages were varied from zero to 400 volts and the voltage on each phase was the same as for the other phases so that the voltages remained balanced. The measured voltages were compared to the calculated voltages. Table 3 and Table 4 show the test results used for Figure 14. In Table 3, the first three columns are the set line-to-neutral voltages of the test equipment. The next three columns show expected line-to-line voltages, and the next three columns show reported line-to-line voltages from the metering device. The next three columns indicate reported line-to-neutral voltages that were calculated by the metering device using and embodiment of the apparatus 200 and methods 800, 1200 described above. The last three columns show measured output voltage of the test equipment using a separate reference metering device. Table 4 includes calculated error for line-to-line voltages and line-to-neutral voltages. The results of Table 4 are included in Figure 14. Note that the error was greatest near zero, but under most conditions the error was very low. Test results reveal that the voltage measurement apparatus 102 may be a viable method for determining line-to-neutral voltages where a neutral or ground is unavailable.

**Table 2**

| Set L-N Volt. | | | Expected L-L V | | | Reported L-L V | | | Reported L-N V | | | CA L-N V | | |
|---|---|---|---|---|---|---|---|---|---|---|---|---|---|---|
| L1N | L2N | L3N | L12 | L23 | L31 | L12 | L23 | L31 | L1N | L2N | L3N | L1N | L2N | L3N |
| 0 | 0 | 0 | 0 | 0 | 0 | 0 | 0 | 0 | 0 | 0 | 0 | 0 | 0 | 0 |
| 5 | 5 | 5 | 9 | 9 | 9 | 0 | 0 | 0 | 0 | 0 | 0 | 5 | 5 | 5 |
| 10 | 10 | 10 | 17 | 17 | 17 | 0 | 0 | 0 | 0 | 0 | 0 | 10 | 10 | 10 |
| 12 | 12 | 12 | 21 | 21 | 21 | 21 | 21 | 21 | 12 | 12 | 12 | 12 | 12 | 12 |
| 14 | 14 | 14 | 24 | 24 | 24 | 24 | 24 | 24 | 14 | 14 | 14 | 14 | 14 | 14 |
| 15 | 15 | 15 | 26 | 26 | 26 | 26 | 26 | 26 | 15 | 15 | 15 | 15 | 15 | 15 |
| 20 | 20 | 20 | 35 | 35 | 35 | 35 | 35 | 35 | 20 | 20 | 20 | 20 | 20 | 20 |
| 30 | 30 | 30 | 52 | 52 | 52 | 52 | 52 | 52 | 30 | 30 | 30 | 30 | 30 | 30 |
| 40 | 40 | 40 | 69 | 69 | 69 | 69 | 69 | 69 | 40 | 40 | 40 | 40 | 40 | 40 |
| 50 | 50 | 50 | 87 | 87 | 87 | 87 | 83 | 86 | 450 | 50 | 50 | 50 | 50 | 50 |
| 60 | 60 | 60 | 104 | 104 | 104 | 104 | 104 | 104 | 60 | 60 | 60 | 60 | 60 | 60 |
| 75 | 75 | 75 | 130 | 130 | 130 | 130 | 130 | 130 | 75 | 75 | 75 | 75 | 75 | 75 |
| 100 | 100 | 100 | 173 | 173 | 173 | 173 | 173 | 173 | 100 | 100 | 100 | 100 | 100 | 100 |
| 120 | 120 | 120 | 208 | 208 | 208 | 208 | 208 | 207 | 120 | 120 | 120 | 120 | 120 | 120 |
| 140 | 140 | 140 | 242 | 242 | 242 | 242 | 242 | 242 | 140 | 140 | 140 | 140 | 140 | 140 |
| 160 | 160 | 160 | 277 | 277 | 277 | 277 | 277 | 277 | 160 | 160 | 160 | 160 | 160 | 160 |
| 180 | 180 | 180 | 312 | 312 | 312 | 312 | 311 | 311 | 180 | 180 | 179 | 180 | 180 | 180 |
| 200 | 200 | 200 | 346 | 346 | 346 | 346 | 346 | 346 | 200 | 200 | 199 | 200 | 200 | 200 |
| 250 | 250 | 250 | 433 | 433 | 433 | 433 | 433 | 432 | 250 | 250 | 249 | 250 | 250 | 250 |
| 300 | 300 | 300 | 520 | 520 | 520 | 519 | 519 | 519 | 300 | 300 | 299 | 300 | 300 | 300 |
| 350 | 350 | 350 | 606 | 606 | 606 | 606 | 606 | 605 | 349 | 350 | 349 | 350 | 350 | 350 |
| 400 | 400 | 400 | 693 | 693 | 693 | 692 | 692 | 692 | 400 | 400 | 399 | 400 | 400 | 400 |

**Table 3**

| | L-to-L Error | | | L-to-N Error | | |
|---|---|---|---|---|---|---|
| Set VLN | VL1-L2 | VL2-L3 | VL3-L1 | VL1N | VL2N | VL3N |
| 0 | #DIV/0! | #DIV/0! | #DIV/0! | #DIV/0! | #DIV/0! | #DIV/0! |

(continued)

| Set VLN | L-to-L Error | | | L-to-N Error | | |
|---|---|---|---|---|---|---|
| | VL1-L2 | VL2-L3 | VL3-L1 | VL1N | VL2N | VL3N |
| 5 | 100.00% | 100.00% | 100.00% | 100.00% | 100.00% | 0.00% |
| 10 | 100.00% | 100.00% | 100.00% | 100.00% | 100.00% | 0.00% |
| 12 | 0.07% | -0.41% | -0.89% | -0.83% | -1.67% | 0.00% |
| 14 | -0.20% | -0.20% | -0.61% | -0.71% | -0.71% | 0.00% |
| 15 | -0.31% | -0.31% | -0.31% | -1.33% | -1.33% | 0.00% |
| 20 | -0.12% | -0.41% | -0.41% | -1.00% | -0.50% | 0.00% |
| 30 | -0.12% | -0.12% | -0.12% | -0.33% | -0.33% | 0.00% |
| 40 | -0.12% | -0.12% | -0.26% | -0.25% | -0.50% | 0.00% |
| 50 | -0.12% | -0.23% | -0.23% | -0.20% | -0.60% | 0.00% |
| 60 | -0.12% | -0.21% | -0.21% | -0.33% | -0.33% | 0.00% |
| 75 | -0.08% | -0.16% | -0.16% | -0.27% | -0.40% | 0.00% |
| 100 | -0.06% | -0.18% | -0.23% | -0.10% | -0.40% | -0.01% |
| 120 | -0.07% | -0.12% | -0.21% | -0.08% | -0.42% | 0.00% |
| 140 | -0.04% | -0.12% | -0.20% | -0.14% | -0.36% | -0.01% |
| 160 | -0.08% | -0.08% | -0.15% | -0.31% | -0.19% | -0.01% |
| 180 | -0.09% | -0.12% | -0.15% | -0.17% | -0.33% | -0.01% |
| 200 | -0.09% | -0.12% | -0.15% | -0.10% | -0.35% | 0.00% |
| 250 | -0.07% | -0.10% | -0.16% | -0.08% | -0.36% | -0.01% |
| 300 | -0.08% | -0.12% | -0.18% | -0.07% | -0.33% | -0.01% |
| 350 | -0.07% | -0.10% | -0.20% | -0.06% | -0.37% | -0.01% |
| 400 | -0.10% | -0.12% | -0.19% | -0.05% | -0.38% | -0.01% |

The described examples and embodiments are to be considered in all respects only as illustrative and not restrictive. This written description uses examples and embodiments to disclose the invention, including best mode, and also to enable any person skilled in the art to practice the invention, including making and using any devices or systems and performing any incorporated methods. The examples and embodiments may be practiced in other specific forms. The patentable scope of this invention is defined by the claims.

**Claims**

1. A method for determining a line-to neutral voltage, the method being performed by an apparatus (200), the method comprising:

measuring (1102; 1202), by a measurement module (202) of said apparatus, three line-to-line voltages for the phases in a three-phase power system, each line-to-line voltage comprising a voltage magnitude;
constructing (1104; 1204), by a triangle module (204) of said apparatus, on a two-dimensional coordinate system with an origin, a phasor triangle comprising the three line-to-line voltages represented as phasors, wherein the magnitudes of the phasors respectively correspond to the voltage magnitudes of the measured line-to-line voltages, and wherein a first phasor $V_{ab}$ originates at a first point and extends in a direction along a horizontal axis of the coordinate system to the origin, a second phasor $V_{bc}$ extends between the origin and a second point, the second point in a direction vertically and horizontally from the origin, and a third phasor $V_{ca}$ extends between the second point and the first point, wherein the first point has a coordinate of $(x_a, y_a)$, the second point has a coordinate of $(x_c, y_c)$, and the origin has a coordinate of $(x_b, y_b)$;

adding (1106; 1208), by a first line module (206) of said apparatus, a first line segment that extends from a point that bisects the second phasor $V_{bc}$ in a direction perpendicular to the second phasor $V_{bc}$ and away from the phasor triangle, the first line segment terminating at a third point;

adding (1108; 1210), by a second line module (208) of said apparatus, a second line segment that extends from a point that bisects the third phasor $V_{ca}$ in a direction perpendicular to the third phasor $V_{ca}$ and away from the phasor triangle, the second line segment terminating at a fourth point, wherein according to a first calculation method:

the length of the first line segment comprises a magnitude of the third phasor $V_{ca}$ divided by the square root of three and multiplied by the square root of one plus the square of the slope of the first line segment and wherein the length of the second line segment comprises a magnitude of the second phasor $V_{bc}$ divided by the square root of three and multiplied by the square root of one plus the square of the slope of the second line segment;

or wherein according to a second calculation method:

the length of the first line segment has a magnitude of the second phasor $V_{bc}$ multiplied by the square root of three and divided by two, which represents a height of a first equilateral triangle constructed on the second phasor $V_{bc}$ and extending away from the phasor triangle and wherein the length of the second line segment has a magnitude of the third phasor $V_{ca}$ multiplied by the square root of three and divided by two, which represents a height of a second equilateral triangle constructed on the third phasor $V_{ca}$ and extending away from the phasor triangle;

adding (1110; 1212), by a third line module (210) of said apparatus, a third line segment from the third point to the first point;

adding (1112; 1214), by a fourth line module (212) of said apparatus, a fourth line segment from the fourth point to the origin, wherein the third line segment intersects the fourth line segment at a neutral point having a coordinate of $(x_n, y_n)$; and

determining (1114; 1216), by a line-to-neutral module (214) of said apparatus, a line-to-neutral voltage, the line-to-neutral voltage comprising a line from the neutral point to a vertex of the phasor triangle, wherein determining a line-to-neutral voltage comprises one or more of:

determining a line-to-neutral voltage for a phasor $V_{an}$ for phase A which comprises determining a line from the neutral point to the first point;

determining a line-to-neutral voltage for a phasor $V_{bn}$ for phase B which comprises determining a line from the neutral point to the origin; and

determining a line-to-neutral voltage for a phasor $V_{cn}$ for phase C which comprises determining a line from the neutral point to the second point.

2. The method of claim 1, further comprising one or more of:

determining a magnitude of phasor $V_{an}$ as

$$V_{an} = \sqrt{(x_a - x_n)^2 + (y_a - y_n)^2};$$

determining a magnitude of phasor $V_{bn}$ as

$$V_{bn} = \sqrt{(x_b - x_n)^2 + (y_b - y_n)^2};$$

and
determining a magnitude of phasor $V_{cn}$ as

$$V_{cn} = \sqrt{(x_c - x_n)^2 + (y_c - y_n)^2}.$$

3. The method of claim 1, wherein:

$x_a$ = the magnitude of the $V_{ab}$ phasor and $y_a = 0$;

$x_b = 0$ and $y_b = 0$; and

$$x_c = \frac{V_{ab}^2 - V_{ca}^2 + V_{bc}^2}{2 \cdot V_{ab}} \quad \text{and} \quad y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)},$$ where $V_{ab}$ is a magnitude of the first phasor

$V_{ab}$, $V_{bc}$ is a magnitude of the second phasor $V_{bc}$, and $V_{ca}$ is a magnitude of the third phasor $V_{ca}$.

**4.** The method of claim 1, wherein the according to the first calculation method the length of the first line segment comprises

$$\frac{V_{ca}}{\sqrt{3}} \cdot \sqrt{1 + \left(\frac{-x_c}{y_c}\right)^2}$$

and wherein the length of the second line segment comprises

$$\frac{V_{bc}}{\sqrt{3}} \cdot \sqrt{1 + \left(\frac{-(x_a - x_c)}{(y_a - y_c)}\right)^2}.$$

**5.** The method of claim 1, wherein according to the first calculation method the third point comprises a coordinate of $(x_{pbc}, y_{pbc})$ and the fourth point comprises a coordinate of $(x_{pca}, y_{pca})$, wherein

$$x_{pbc} = \frac{x_c}{2} - \frac{V_{ca}}{\sqrt{3}};$$

$$y_{pbc} = \frac{y_c}{2} - \frac{-x_c}{y_c} \cdot \frac{V_{ca}}{\sqrt{3}};$$

$$x_{pca} = x_c + \frac{x_a - x_c}{2} + \frac{V_{bc}}{\sqrt{3}};$$

and

$$y_{pca} = \frac{y_c}{2} + \frac{-(x_a - x_c)}{(y_a - y_c)} \cdot \frac{V_{bc}}{\sqrt{3}}.$$

**6.** The method of claim 5, wherein:

$$x_n = \frac{\dfrac{y_{pbc}}{x_a - x_{pbc}} \cdot x_a}{\dfrac{y_{pca}}{x_{pca}} + \dfrac{y_{pbc}}{x_a - x_{pbc}}};$$

and

$$y_n = \frac{y_{pca}}{x_{pca}} \cdot x_n.$$

7. The method of claim 6, wherein where $y_n$ is less than zero then $y_n = 0$, and where $y_n$ is greater than or equal to zero and greater than $y_c$ then $y_n = y_c$.

8. The method of claim 7, wherein where $x_n$ is less than zero then $x_n = 0$, and where $x_n$ is greater than or equal to zero and greater than $x_a$ then $x_n = x_a$, and where $x_n$ is greater than or equal to zero and less than or equal to $x_a$ and $y_c = y_n$ then $x_n = x_c$.

9. The method of claim 1, wherein according to the second calculation method the third point comprises a coordinate of ($x_{pbc}$, $y_{pbc}$) and the fourth point comprises a coordinate of ($x_{pca}$, $y_{pca}$), wherein

$$x_{pbc} = \frac{x_c - y_c \cdot \sqrt{3}}{2};$$

$$y_{pbc} = \frac{y_c + x_c \cdot \sqrt{3}}{2};$$

$$x_{pca} = x_a + \frac{x_c - x_a + \sqrt{3} \cdot y_c}{2};$$

and

$$y_{pca} = \frac{(y_c - y_a) + \sqrt{3} \cdot (x_a - x_c)}{2}.$$

10. The method of claim 9, wherein:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}};$$

and

$$y_n = \frac{y_{pca}}{x_{pca}} \cdot x_n.$$

11. The method of claim 1, wherein:

the line-to-line voltages are measured at a location in the three-phase power system where a neutral connection is unavailable for measurement; and/or
the three-phase power system comprises an ungrounded power system; and/or
the three-phase power system comprises unbalanced voltages; and/or
the first phasor $V_{ab}$, the second phasor $V_{bc}$, and the third phasor $V_{ca}$ are separated by 120 degrees.

12. An apparatus (102) for determining a line-to-line voltage, the apparatus comprising a processor, wherein the processor is adapted to carry out all the steps of the method according to method claims 1 to 11.

**Patentansprüche**

1. Verfahren zur Ermittlung einer Außenleiter-Neutralleiter-Spannung, wobei das Verfahren von einer Vorrichtung (200) ausgeführt wird und das Verfahren umfasst:

Messen (1102; 1202), mittels eines Messmoduls (202) der Vorrichtung, dreier Außenleiterspannungen für die Phasen in einem Dreiphasenspannungssystem, wobei jede Außenleiterspannung einen Spannungsbetrag hat;

Erstellen (1104; 1204), mittels eines Dreieckmoduls (204) der Vorrichtung in einem zweidimensionalen Koordinatensystem mit Ursprung, eines Zeigerdreiecks, das die drei Au-ßenspannungen enthält, die als Zeiger dargestellt sind, wobei die Beträge der Zeiger entsprechend den Spannungsbeträgen der gemessenen Außenleiterspannungen zugeordnet sind, und wobei ein erster Zeiger $V_{ab}$ an einem ersten Punkt entspringt und sich in einer Richtung entlang einer horizontalen Achse des Koordinatensystems zu dem Ursprung erstreckt, ein zweiter Zeiger $V_{bc}$ sich zwischen dem Ursprung und einem zweiten Punkt erstreckt, wobei der zweite Punkt in einer vertikal und horizontal zu dem Ursprung verschobenen Richtung liegt, und ein dritter Zeiger $V_{ca}$ sich zwischen dem zweiten Punkt und dem ersten Punkt erstreckt, wobei der erste Punkt eine Koordinate ($x_a$, $y_a$) hat, der zweite Punkt eine Koordinate ($x_c$, $y_c$) hat und der Ursprung eine Koordinate ($x_b$, $y_b$) hat;

Addieren (1106; 1208), durch ein erstes Linienmodul (206) der Vorrichtung, eines ersten Liniensegments, das sich ausgehend von einem Punkt, der den zweiten Zeiger $V_{bc}$ in einer Richtung senkrecht zu dem zweiten Zeiger $V_{bc}$ halbiert, weg von dem Zeigerdreieck erstreckt, wobei das erste Liniensegment an dem dritten Punkt endet;

Addieren (1108; 1210), mittels eines zweiten Linienmoduls (208) der Vorrichtung, eines zweiten Liniensegments, das sich von einem Punkt, der den dritten Zeiger $V_{ca}$ in einer Richtung senkrecht zu dem dritten Zeiger $V_{ca}$ halbiert, weg von dem Zeigerdreieck erstreckt, wobei das zweite Liniensegment an einem vierten Punkt endet, wobei gemäß einem ersten Berechnungsverfahren:

die Länge des ersten Liniensegments einem Betrag des dritten Zeigers $V_{ca}$ geteilt durch die Quadratwurzel von drei und multipliziert mit der Quadratwurzel von eins plus dem Quadrat der Steigung des ersten Liniensegments entspricht und wobei die Länge des zweiten Liniensegments einem Betrag des zweiten Zeigers $V_{bc}$ geteilt durch die Quadratwurzel von drei multipliziert mit der Quadratwurzel von eins plus dem Quadrat der Steigung des zweiten Liniensegments entspricht;

oder wobei gemäß einem zweiten Berechnungsverfahren:

die Länge des ersten Liniensegments einem Betrag des zweiten Zeigers $V_{bc}$ multipliziert mit der Quadratwurzel von drei geteilt durch zwei entspricht und eine Höhe eines ersten gleichseitigen Dreiecks repräsentiert, das auf dem zweiten Zeiger $V_{bc}$ konstruiert ist, und sich von dem Zeigerdreieck weg erstreckt, und wobei die Länge des zweiten Liniensegments einem Betrag des dritten Zeigers $V_{ca}$ multipliziert mit der Quadratwurzel von drei und geteilt durch zwei entspricht und eine Höhe eines zweiten gleichseitigen Dreiecks repräsentiert, das auf dem dritten Zeiger $V_{ca}$ konstruiert ist, und sich von dem Zeigerdreieck weg erstreckt;

Addieren (1110; 1212), mittels eines dritten Linienmoduls (210) der Vorrichtung, eines dritten Liniensegments von dem dritten Punkt zu dem ersten Punkt;

Addieren (1112; 1214), mittels eines vierten Linienmoduls (212) der Vorrichtung, eines vierten Liniensegments von dem vierten Punkt zum Ursprung, wobei das dritte Liniensegment das vierte Liniensegment an einem neutralen Punkt mit einer Koordinate ($x_n$, $y_n$) schneidet; und

Ermitteln (1114; 1216), mittels eines Außenleiter-Neutralleiter-Moduls (214) der Vorrichtung, einer Außenleiter-Neutralleiter-Spannung, wobei die Außenleiter-Neutralleiter-Spannung einer Linie von dem neutralen Punkt zu einem Scheitelpunkt des Zeigerdreiecks entspricht, wobei Ermitteln einer Außenleiter-Neutralleiter-Spannung einen oder mehrere der folgenden Schritte umfasst:

Ermitteln einer Außenleiter-Neutralleiter-Spannung für einen Zeiger $V_{an}$ für eine Phase A, wobei Ermitteln einer Linie von dem neutralen Punkt zu dem ersten Punkt enthalten ist;

Ermitteln einer Außenleiter-Neutralleiter-Spannung für einen Zeiger $V_{bn}$ für eine Phase B, wobei Ermitteln einer Linie von dem neutralen Punkt zum Ursprung enthalten ist; und

Ermitteln einer Außenleiter-Neutralleiter-Spannung für einen Zeiger $V_{cn}$ für eine Phase C, wobei Ermitteln einer Linie von dem neutralen Punkt zu dem zweiten Punkt enthalten ist.

2. Verfahren nach Anspruch 1, das ferner umfasst:

Ermitteln eines Betrags eines Zeigers $V_{an}$ als

$$V_{an} = \sqrt{(x_a - x_n)^2 + (y_a - y_n)^2} \; ;$$

und/oder
Ermitteln eines Betrags eines Zeigers $V_{bn}$ als

$$V_{bn} = \sqrt{(x_b - x_n)^2 + (y_b - y_n)^2} \; ;$$

und/oder
Ermitteln eines Betrags eines Zeigers $V_{cn}$ als

$$V_{cn} = \sqrt{(x_c - x_n)^2 + (y_c - y_n)^2} \; .$$

3. Verfahren nach Anspruch 1, wobei:

$x_a$ = der Betrag des Zeigers $V_{ab}$ und $y_a = 0$ ist;
$x_b = 0$ und $y_b = 0$; und

$$x_c = \frac{V_{ab}^2 - V_{ca}^2 + V_{bc}^2}{2 \cdot V_{ab}} \text{ und } y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)} \text{ , wobei } V_{ab} \text{ ein Betrag des ersten}$$

Zeigers $V_{ab}$ ist, $V_{bc}$ ein Betrag des zweiten Zeigers $V_{bc}$ ist und $V_{ca}$ ein Betrag des dritten Zeigers $V_{ca}$ ist.

4. Verfahren nach Anspruch 1, wobei gemäß dem ersten Berechnungsverfahren die Länge des ersten Liniensegmentes gegeben ist

$$\frac{V_{ca}}{\sqrt{3}} \cdot \sqrt{1 + \left(\frac{-x_c}{y_c}\right)^2}$$

und wobei die Länge des zweiten Liniensegments gegeben ist

$$\frac{V_{bc}}{\sqrt{3}} \cdot \sqrt{1 + \left(\frac{-(x_a - x_c)}{(y_a - y_c)}\right)^2} \; .$$

5. Verfahren nach Anspruch 1, wobei gemäß dem ersten Berechnungsverfahren der dritte Punkt eine Koordinate ($x_{pbc}$, $y_{pbc}$) und der vierte Punkte eine Koordinate ($x_{pca}$, $y_{pca}$) hat, wobei

$$x_{pbc} = \frac{x_c}{2} - \frac{V_{ca}}{\sqrt{3}};$$

$$y_{pbc} = \frac{y_c}{2} - \frac{-x_c}{y_c} \cdot \frac{V_{ca}}{\sqrt{3}};$$

$$x_{pca} = x_c + \frac{x_a - x_c}{2} + \frac{V_{bc}}{\sqrt{3}};$$

und

$$y_{pca} = \frac{y_c}{2} + \frac{-(x_a - x_c)}{(y_a - y_c)} \cdot \frac{V_{bc}}{\sqrt{3}}.$$

6. Das Verfahren nach Anspruch 5, wobei:

$$x_n = \frac{\dfrac{y_{pbc}}{x_a - x_{pbc}} \cdot x_a}{\dfrac{y_{pca}}{x_{pca}} + \dfrac{y_{pbc}}{x_a - x_{pbc}}};$$

und

$$y_n = \frac{y_{pca}}{x_{pca}} \cdot x_n.$$

7. Verfahren nach Anspruch 6, wobei, wenn $y_n$ kleiner als Null ist, dann $y_n = 0$ gilt, und wenn $y_n$ größer oder gleich Null und größer als $y_c$ ist, dann $y_a = y_c$ gilt.

8. Verfahren nach Anspruch 7, wobei, wenn $x_n$ kleiner als Null ist, dann $x_n = 0$ gilt, und wenn $x_n$ größer oder gleich Null und größer als $x_a$ ist, dann $x_n = x_a$ gilt, und wenn $x_n$ größer oder gleich Null und kleiner oder gleich $x_a$ ist und $y_c = y_n$, dann $x_n = x_c$ gilt.

9. Verfahren nach Anspruch 1, wobei gemäß dem zweiten Berechnungsverfahren der dritte Punkt eine Koordinate $(x_{pbc}, y_{pbc})$ hat und der vierte Punkt eine Koordinate $(x_{pca}, y_{pca})$ hat, wobei

$$x_{pbc} = \frac{x_c - y_c \cdot \sqrt{3}}{2};$$

$$y_{pbc} = \frac{y_c + x_c \cdot \sqrt{3}}{2};$$

$$x_{pca} = x_a + \frac{x_c - x_a + \sqrt{3} \cdot y_c}{2};$$

und

$$y_{pca} = \frac{(y_c - y_a) + \sqrt{3} \cdot (x_a - x_c)}{2}.$$

10. Verfahren nach Anspruch 9, wobei:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}};$$

und

$$y_n = \frac{y_{pca}}{x_{pca}} \cdot x_n.$$

**11.** Verfahren nach Anspruch 1, wobei:

die Außenleiterspannungen an einer Stelle in dem Dreiphasenspannungssystem gemessen werden, an der eine Verbindung zum Neutralleiter für die Messung nicht verfügbar ist; und/oder
das Dreiphasenspannungssystem ein nicht geerdetes Spannungssystem umfasst; und/oder
das Dreiphasenspannungssystem nicht ausgeglichene Spannungen aufweist; und/oder
der erste Zeiger $V_{ab}$, der zweite Zeiger $V_{bc}$ und der dritte Zeiger $V_{ca}$ einen Versatz von 120 Grad haben.

**12.** Vorrichtung (102) zur Ermittlung von Spannungen zwischen Außenleitern, wobei die Vorrichtung einen Prozessor aufweist, wobei der Prozessor ausgebildet ist, alle Schritte des Verfahrens nach einem der Verfahrensansprüche 1 bis 11 auszuführen.


**Revendications**

**1.** Procédé de détermination d'une tension phase-neutre, le procédé étant réalisé par un appareil (200), le procédé consistant à :

mesurer (1102; 1202), à l'aide d'un module de mesure (202) dudit appareil, trois tensions de ligne à ligne pour les phases dans un système d'alimentation triphasé, chaque tension de ligne à ligne comprenant une grandeur de tension;
construire (1104; 1204), à l'aide d'un module de triangle (204) dudit appareil, sur un système de coordonnées à deux dimensions avec une origine, un triangle de phaseur comprenant les trois tensions de ligne à ligne représentées comme phaseurs, les magnitudes des phaseurs correspondant respectivement aux magnitudes de tension de la tension de ligne à ligne mesurée; et dans lequel un premier phaseur $V_{ab}$ part d'un premier point et se prolonge dans une direction le long d'un axe horizontal du système de coordonnées jusqu'à l'origine, un second phaseur $V_{bc}$ relie l'origine à un deuxième point, le deuxième point partant dans une direction verticale et horizontalement à partir de l'origine, et un troisième phaseur $V_{ca}$ relie le deuxième second point au premier point, où le premier point possède une coordonnée ($x_a$, $y_a$), le deuxième point possède une coordonnée ($x_c$, $y_c$) et l'origine possède une coordonnée ($x_b$, $y_b$);
ajouter (1106; 1208), à l'aide d'un premier module de ligne (206) dudit appareil, un premier segment ligne à partir d'un point qui coupe le deuxième phaseur $V_{bc}$ dans une direction perpendiculaire au deuxième phaseur $V_{bc}$ et à distance du triangle de phaseur, le premier segment de ligne se terminant à un troisième point;
ajouter (1108; 1210), à l'aide d'un deuxième module de ligne (208) dudit appareil, un deuxième segment ligne à partir d'un point qui coupe le troisième phaseur $V_{ca}$ dans une direction perpendiculaire au troisième phaseur $V_{ca}$ et à distance du triangle de phaseur, le deuxième segment de ligne se terminant à un quatrième point, dans lequel selon un premier procédé de calcul:

la longueur du premier segment de ligne comprend une grandeur du troisième phaseur $V_{ca}$ divisée par la racine carrée de trois et multipliée par la racine carrée de un plus le carré de la pente du premier segment de ligne et dans lequel le longueur du deuxième segment de ligne comprend une magnitude du second phaseur $V_{bc}$ divisé par la racine carrée de trois et multipliée par la racine carrée de un plus le carré de la pente du deuxième segment de ligne;
ou dans lequel selon un deuxième procédé de calcul:

la longueur du premier segment de ligne présente une magnitude du deuxième phaseur $V_{bc}$ multipliée par la racine carrée de trois et divisée par deux, ce qui représente une hauteur d'un premier triangle équilatéral construit sur le deuxième phaseur $V_{bc}$ et se prolongeant à distance du triangle de phaseur et dans lequel la longueur du deuxième segment de ligne présente une magnitude du troisième phaseur $V_{ca}$ multipliée par la racine carrée de trois et divisée par deux, ce qui représente une hauteur d'un deuxième triangle équilatéral construit sur le troisième phaseur $V_{ca}$ et se prolongeant à distance du triangle de phaseur;

ajouter (1110; 1212), à l'aide d'un troisième module de ligne (210) dudit appareil, un troisième segment de ligne allant du troisième point au premier point;

ajouter (1112; 1214), à l'aide d'un quatrième module de ligne (212) dudit appareil, un quatrième segment de ligne allant du quatrième point à l'origine, dans lequel le troisième segment de ligne coupe le quatrième segment de ligne en un point neutre de coordonnée $(x_n, y_n)$; et

déterminer (1114; 1216), à l'aide d'un module de ligne à neutre (214) dudit appareil, une tension de ligne à neutre, la tension de ligne à neutre comprenant une ligne allant du point neutre à un sommet du triangle de phaseur, dans lequel la détermination d'une tension de ligne à neutre comprend l'une ou plusieurs des étapes consistant à:

déterminer une tension de ligne à neutre pour un phaseur $V_{an}$ pour la phase A qui consiste à déterminer une ligne entre le point neutre et le premier point;

déterminer une tension de ligne à neutre pour un phaseur $V_{bn}$ pour la phase B qui consiste à déterminer une ligne entre le point neutre et l'origine; et

déterminer une tension de ligne à neutre pour un phaseur $V_{cn}$ pour la phase C qui consiste à déterminer une ligne entre le point neutre et le deuxième point.

2. Procédé selon la revendication 1, comprenant l'une ou plusieurs des étapes consistant à:

déterminer une magnitude de phaseur $V_{an}$ comme

$$V_{an} = \sqrt{(x_a - x_n)^2 + (y_a - y_n)^2};$$

déterminer une magnitude de phaseur $V_{bn}$ comme

$$V_{bn} = \sqrt{(x_b - x_n)^2 + (y_b - y_n)^2}$$

et

déterminer une magnitude de phaseur $V_{cn}$ comme

$$V_{cn} = \sqrt{(x_c - x_n)^2 + (y_c - y_n)^2}.$$

3. Procédé selon la revendication 1, dans lequel:

$x_a$ = la magnitude du phaseur $V_{ab}$ et $y_a = 0$;

$$x_b = 0 \text{ et } y_b = 0;$$

et

$$x_c = \frac{V_{ab}^2 - V_{ca}^2 + V_{bc}^2}{2 \cdot V_{ab}} \quad \text{et} \quad y_c = V_{ca} \cdot \sqrt{1 - \left(\frac{V_{bc}^2 - V_{ab}^2 - V_{ca}^2}{4 \cdot V_{ab}^2 \cdot V_{ca}^2}\right)},$$

où $V_{ab}$ est une magnitude du premier phaseur $V_{ab}$, $V_{bc}$ est une magnitude du deuxième phaseur $V_{bc}$ et $V_{ca}$ est une magnitude du troisième phaseur $V_{ca}$.

4. Procédé selon la revendication 1, dans lequel selon le premier procédé de calcul, la longueur du premier segment de ligne comprend

$$\frac{V_{ca}}{\sqrt{3}} \cdot \sqrt{1 + \left(\frac{-x_c}{y_c}\right)^2}$$

et dans lequel la longueur du deuxième segment de ligne comprend

$$\frac{V_{bc}}{\sqrt{3}} \cdot \sqrt{1 + \left(\frac{-(x_a - x_c)}{(y_a - y_c)}\right)^2} \cdot$$

5. Procédé selon la revendication 1, dans lequel, selon le premier procédé de calcul, le troisième point comprend une coordonnée $(X_{pbc}, y_{pbc})$ et le quatrième point comprend une coordonnée $(x_{pca}, y_{pca})$, dans lequel

$$x_{pbc} = \frac{x_c}{2} - \frac{V_{ca}}{\sqrt{3}};$$

$$y_{pbc} = \frac{y_c}{2} - \frac{-x_c}{y_c} \cdot \frac{V_{ca}}{\sqrt{3}};$$

et

$$x_{pca} = x_c + \frac{x_a - x_c}{2} + \frac{V_{bc}}{\sqrt{3}};$$

$$y_{pca} = \frac{y_c}{2} + \frac{-(x_a - x_c)}{(y_a - y_c)} \cdot \frac{V_{bc}}{\sqrt{3}}.$$

6. Procédé selon la revendication 5, dans lequel:

$$x_n = \frac{\frac{y_{pbc}}{x_a - x_{pbc}} \cdot x_a}{\frac{y_{pca}}{x_{pca}} + \frac{y_{pbc}}{x_a - x_{pbc}}};$$

et

$$y_n = \frac{y_{pca}}{x_{pca}} \cdot x_n.$$

7. Procédé selon la revendication 6, dans lequel, si $y_n$ est inférieur à zéro alors $y_n = 0$, et où $y_n$ est supérieur ou égal à zéro et supérieur à $y_c$, alors $y_n = y_c$.

8. Procédé selon la revendication 7, dans lequel, si $x_n$ est inférieur à zéro alors $x_n = 0$, et où $x_n$ est supérieur ou égal à zéro et supérieur à $x_a$, alors $x_n = x_a$, et où $x_n$ est supérieur ou égal à zéro et inférieur ou égal à $x_a$ et $y_c = y_n$ alors $x_n = x_c$.

9. Procédé selon la revendication 1, dans lequel, selon le deuxième procédé de calcul, le troisième point comprend une coordonnée $(x_{pbc}, y_{pbc})$ et le quatrième point comprend une coordonnée $(X_{pca}, y_{pca})$, dans lequel

$$x_{pbc} = \frac{x_c - y_c \cdot \sqrt{3}}{2};$$

$$y_{pbc} = \frac{y_c + x_c \cdot \sqrt{3}}{2};$$

31

$$x_{pca} = x_a + \frac{x_c - x_a + \sqrt{3} \cdot y_c}{2};$$

et

$$y_{pca} = \frac{(y_c - y_a) + \sqrt{3} \cdot (x_a - x_c)}{2}.$$

**10.** Procédé selon la revendication 9, dans lequel:

$$x_n = \frac{\dfrac{x_a \cdot y_{pbc}}{x_a - x_{pbc}}}{\dfrac{y_{pca}}{x_{pca}} + \dfrac{y_{pbc}}{x_a - x_{pbc}}};$$

et

$$y_n = \frac{y_{pca}}{x_{pca}} \cdot x_n$$

**11.** Procédé selon la revendication 1, dans lequel:

les tensions de ligne à ligne sont mesurées à un emplacement dans le système d'alimentation triphasé où une connexion neutre est indisponible pour la mesure; et/ou
le système d'alimentation triphasé comprend un système d'alimentation non mis à la terre; et/ou
le système d'alimentation triphasé comprend des tensions déséquilibrées; et/ou
le premier phaseur $V_{ab}$, le deuxième phaseur $V_{bc}$ et le troisième phaseur $V_{ca}$ sont séparés de 120 degrés.

**12.** Appareil (102) permettant de déterminer une tension de ligne à ligne, l'appareil comprenant un processeur, dans lequel le processeur est prévu pour effectuer toutes les étapes du procédé selon les revendications de procédé 1 à 11.

FIG. 1

200

**Voltage Measurement Apparatus**
102

| | |
|---|---|
| Measurement Module 202 | Triangle Module 204 |
| First Line Module 206 | Second Line Module 208 |
| Third Line Module 210 | Fourth Line Module 212 |
| Line-To-Neutral Module 214 | Line-To-Neutral Magnitude Module 216 |

# FIG. 2

FIG. 3

FIG. 4

FIG. 5

FIG. 6

FIG. 7

FIG. 8

FIG. 9

FIG. 10

1100

Begin

1102 — Measure Line-To-Line Voltages

1104 — Construct Triangle

1106 — Add First Line that Bisects Second Phasor

1108 — Add Second Line that Bisects Third Phasor

1110 — Add Third Line

1112 — Add Fourth Line

1114 — Determine Line-To-Neutral Voltages

End

FIG. 11

1200

Begin

1202 — Measure Line-To-Line Voltages

1204 — Construct Triangle

1206 — Determine Coordinates of Vertices

1208 — Add First Line that Bisects Second Phasor

1210 — Add Second Line that Bisects Third Phasor

1212 — Add Third Line

1214 — Add Fourth Line

1216 — Determine Neutral Point Coordinates

A

FIG. 12A

1200

A

1218　$y_n < 0?$　Yes　1220　$y_n = 0$

No

1222　$y_n > y_c?$　Yes　1224　$y_n = y_c$

No

1226　Do not modify $y_n$

1228　$x_n < 0?$　Yes　1230　$x_n = 0$

No

1232　$x_n > x_a?$　Yes　1234　$x_n = x_a$

No

1236　$y_c = y_n?$　Yes　1238　$x_n = x_c$

No

1240　Do not modify $x_n$

1242　Determine Line-To-Neutral Voltages

End

FIG. 12B

FIG. 13

**Reported Voltage Error Under Balanced Conditions**

FIG. 14

**EP 2 940 821 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6466466 B1
- US 4887018 A

**Non-patent literature cited in the description**

- Calculating Line-to-Line Voltages from Line-to-Neutral Measurements with the NI 9225. *National Instruments,* 18 December 2008, 1-3